# FASCICULE DE BREVET EUROPEEN

(11) **EP 3 655 944 B1**
(45) Date de publication et mention de la délivrance du brevet: **25.12.2024**
(21) Numéro de dépôt: 18762362.4
(22) Date de dépôt: 19.07.2018
(51) Int. Cl.: G09G 3/20, H01L 27/15

(54) **DISPOSITIF OPTOELECTRONIQUE**
OPTOELEKTRONISCHE VORRICHTUNG
OPTOELECTRONIC DEVICE

(30) Priorité: 21.07.2017 FR 1756985
(43) Date de publication de la demande: 27.05.2020
(73) Titulaire: Aledia, 38130 Echirolles (FR)
(72) Inventeur: HUGON, Xavier, 38470 Teche (FR); GILET, Philippe, 38470 Teche (FR); ROBIN, Ivan-Christophe, 38000 Grenoble (FR); BOUHAMRI, Zine, 38000 Grenoble (FR); MERCIER, Frédéric, 38500 Saint Nicolas de Macherin (FR); CHARBONNIER, Matthieu, 38600 Fontaine (FR)
(74) Mandataire: Cabinet Beaumont
(86) Numéro de dépôt international: PCT/FR2018/051850
(87) Numéro de publication internationale: WO 2019/016482

(56) Documents cités:
- US-A- 5 739 802
- US-A1- 2004 004 443
- US-A1- 2005 169 600
- US-A1- 2006 132 452
- US-A1- 2008 165 120
- US-A1- 2009 073 079
- US-A1- 2011 050 658

## Description

La présente demande de brevet revendique la priorité de la demande de brevet français FR17/56985.

### Domaine

La présente demande concerne un dispositif optoélectronique, notamment un écran d'affichage ou un dispositif de projection d'images, comprenant des diodes électroluminescentes, appelées LEDs par la suite, à base de matériaux semiconducteurs, et leurs procédés de commande.

### Exposé de l'art antérieur

Un pixel d'une image correspond à l'élément unitaire de l'image affichée par le dispositif optoélectronique. Lorsque le dispositif optoélectronique est un écran d'affichage d'images couleur, il comprend en général pour l'affichage de chaque pixel de l'image au moins trois composants, également appelés sous-pixels d'affichage, qui émettent chacun un rayonnement lumineux sensiblement dans une seule couleur (par exemple, le rouge, le vert et le bleu). La superposition des rayonnements émis par ces trois sous-pixels d'affichage fournit à l'observateur la sensation colorée correspondant au pixel de l'image affichée. Dans ce cas, on appelle pixel d'affichage du dispositif optoélectronique l'ensemble formé par les trois sous-pixels d'affichage utilisés pour l'affichage d'un pixel d'une image.

Chaque sous-pixel d'affichage peut comprendre une source lumineuse, notamment une diode électroluminescente par exemple à base de matériaux semiconducteurs. Un procédé connu de fabrication d'un dispositif optoélectronique, notamment un écran d'affichage ou un dispositif de projection d'images, comprenant des diodes électroluminescentes, appelé procédé "pick and place", consiste à fabriquer les diodes électroluminescentes sous la forme de composants distincts, et à placer chaque diode électroluminescente à une position souhaitée sur un support qui peut comprendre des pistes conductrices pour la connexion électrique des diodes électroluminescentes. US 2009/073079 A1 divulge un écran d'affichage à matrice passive de l'art antérieur.

Un inconvénient d'un tel procédé est qu'il nécessite généralement de placer avec précision les diodes électroluminescentes sur le support. Ceci nécessite la mise en oeuvre de procédés d'alignement d'autant plus complexes que les dimensions des diodes électroluminescentes sont réduites.

Un autre inconvénient d'un tel procédé est qu'une augmentation de la résolution du dispositif optoélectronique se traduit par une augmentation du nombre de transferts de diodes électroluminescentes sur le support et donc une augmentation de la durée de la fabrication du dispositif optoélectronique qui peut ne pas être compatible avec une fabrication à une échelle industrielle.

Pour la réalisation d'un grand écran à LEDs composé de composants LEDs unitaires assemblées, les LEDs doivent être assemblées avec des circuits de commande qui contrôlent un certain nombre de LEDs. Les différentes unités sont reliées entre elles par des fils. Cet assemblage réduit la quantité de données qu'on peut transmettre et il est difficile d'afficher un flux vidéo.

Pour les écrans à LEDs de taille micrométrique, appelés pLEDs par la suite, pour les formats type TV, tablette, téléphone intelligent (en anglais smart phone) qui sont en cours de développement par plusieurs industriels, une matrice active est nécessaire pour afficher un flux vidéo avec une haute résolution. Actuellement les matrices actives pour les écrans sont réalisées en transistors en couches minces, ou TFT (sigle anglais pour Thin Film Transistor). Les TFT utilisent des dépôts de silicium amorphe ou polycristallin sur de grandes surfaces de verre et nécessitent l'utilisation de procédés de microélectronique complexes sur de grandes surfaces.

L'utilisation de pixels dits intelligents intégrant avec les LEDs ou pLEDs de l'électronique de commande pourrait permettre de réaliser des matrices actives sans TFT. Ces matrices actives pourraient être réalisées sur de très grandes surfaces car elles s'appuient sur l'électronique embarquée sous le pixel. D'autre part cette électronique profiterait des performances de la technologie à base de silicium. Les grands écrans extérieurs ou intérieurs intégrant cette technologie pourraient être commandés par matrice active, augmentant de ce fait leur luminosité et, en outre, pourraient afficher des flux de données plus importants.

Un autre intérêt de l'approche est la réalisation de grands écrans à très grand nombre de pixels. On n'est pas contraint par des matrices actives en TFT prédéfinies ou par une électronique à assembler.

### Résumé

Ainsi, un objet d'un mode de réalisation est de pallier au moins en partie les inconvénients des dispositifs optoélectroniques comprenant des diodes électroluminescentes décrits précédemment.

Un autre objet d'un mode de réalisation est de réduire le nombre de transferts de composants sur le support du dispositif optoélectronique lors de la fabrication du dispositif optoélectronique.

Un autre objet d'un mode de réalisation est de réduire les contraintes de précision lors du placement de composants sur le support du dispositif optoélectronique.

Un autre objet d'un mode de réalisation est que les dispositifs optoélectroniques puissent être fabriqués à une échelle industrielle et à bas coût.

Un autre objet est que le dispositif optoélectronique comprend une matrice active.

Un autre objet est que le dispositif optoélectronique permet l'affichage d'un flux vidéo.

Ainsi, un mode de réalisation prévoit un procédé de commande d'un dispositif optoélectronique selon la revendication 1.

Selon un mode de réalisation, le procédé comprend, après la première phase, une deuxième phase comprenant la transmission de données aux circuits électroniques connectés à ladite une des premières électrodes et à ladite une des deuxièmes électrodes au quatrième potentiel en faisant varier le potentiel de ladite une des premières électrodes entre le premier potentiel et le deuxième potentiel et en maintenant le potentiel de ladite une des deuxièmes électrodes au quatrième potentiel.

Selon un mode de réalisation, le procédé comprend, pendant la deuxième phase, la transmission de signaux à durée discrète et la transmission de signaux à durée non discrète.

Selon un mode de réalisation, pendant la deuxième phase, les circuits électroniques reliés à ladite une des premières électrodes et non reliés à ladite une des deuxièmes électrodes ne traitent pas les données transmises.

Selon un mode de réalisation, le procédé comprend l'extinction des diodes électroluminescentes des pixels d'affichage reliés à ladite une des premières électrodes et/ou à ladite une des deuxièmes électrodes.

Selon un mode de réalisation, chaque premier circuit optoélectronique comprend un premier transistor monté en série avec la première diode électroluminescente, la deuxième phase comprenant le maintien de ladite une des premières électrodes au premier potentiel pendant une première durée et le premier transistor est commandé à un premier niveau de conduction qui dépend de la première durée.

Selon un mode de réalisation, chaque pixel d'affichage comprend au moins un deuxième circuit optoélectronique relié au circuit électronique dudit pixel d'affichage et comprenant au moins une deuxième diode électroluminescente et un deuxième transistor monté en série avec la deuxième diode électroluminescente, la deuxième phase comprenant le maintien de ladite une des premières électrodes au premier potentiel pendant une deuxième durée et le deuxième transistor est commandé à un deuxième niveau de conduction qui dépend de la troisième durée.

Selon un mode de réalisation, chaque pixel d'affichage comprend au moins un troisième circuit optoélectronique relié au circuit électronique dudit pixel d'affichage et comprenant au moins une troisième diode électroluminescente et un troisième transistor monté en série avec la troisième diode électroluminescente, la deuxième phase comprenant le maintien de ladite une des premières électrodes au premier potentiel pendant une troisième durée et le troisième transistor est commandé à un troisième niveau de conduction qui dépend de la troisième durée.

Selon un mode de réalisation, les première, deuxième et troisième durées sont successives, ladite une des premières électrodes étant maintenue au deuxième potentiel entre la première durée et la deuxième durée et pendant la deuxième durée et la troisième durée.

Un mode de réalisation prévoit également un dispositif optoélectronique selon la revendication 10.

Selon un mode de réalisation, le circuit de commande est adapté, après la première phase, pendant une deuxième phase, à transmettre des données aux circuits électroniques connectés à ladite une des premières électrodes et à ladite une des deuxièmes électrodes en faisant varier le potentiel de ladite une des premières électrodes entre le premier potentiel et le deuxième potentiel et en maintenant le potentiel de ladite une des deuxièmes électrodes au quatrième potentiel.

Selon un mode de réalisation, le circuit de commande est adapté, pendant la deuxième phase, à transmettre des signaux à durée discrète et des signaux à durée non discrète.

Selon un mode de réalisation, pendant la deuxième phase, les circuits électroniques reliés à ladite une des premières électrodes et non reliés à ladite une des deuxièmes électrodes sont adaptés à ne pas traiter les données transmises.

Selon un mode de réalisation, les circuits électroniques reliés à ladite une des premières électrodes et/ou à ladite une des deuxièmes électrodes sont adaptés à éteindre les diodes électroluminescentes associées.

Selon un mode de réalisation, chaque premier circuit optoélectronique comprend un premier transistor monté en série avec la première diode électroluminescente, le circuit de commande étant adapté, pendant la deuxième phase, à maintenir ladite une des premières électrodes au premier potentiel pendant une première durée, le premier circuit optoélectronique étant adapté à rendre passant le premier transistor à un premier niveau de conduction qui dépend de la première durée.

Selon un mode de réalisation, chaque pixel d'affichage comprend au moins un deuxième circuit optoélectronique relié au circuit électronique dudit pixel d'affichage et comprenant au moins une deuxième diode électroluminescente et un deuxième transistor monté en série avec la deuxième diode électroluminescente, le circuit de commande étant adapté, pendant la deuxième phase, à maintenir ladite une des premières électrodes au premier potentiel pendant une deuxième durée, le deuxième circuit optoélectronique étant adapté à rendre passant le deuxième transistor à un deuxième niveau de conduction qui dépend de la deuxième durée.

Selon un mode de réalisation, chaque pixel d'affichage comprend au moins un troisième circuit optoélectronique relié au circuit électronique et comprenant au moins une troisième diode électroluminescente et un troisième transistor monté en série avec la troisième diode électroluminescente, le circuit de commande étant adapté, pendant la deuxième phase, à maintenir ladite une des premières électrodes au premier potentiel pendant une troisième durée, le troisième circuit optoélectronique étant adapté à rendre passant le troisième transistor à un troisième niveau de conduction qui dépend de la troisième durée.

Selon un mode de réalisation, les première, deuxième et troisième durées sont successives, le circuit de commande étant adapté à maintenir ladite une des premières électrodes au deuxième potentiel entre la première durée et la deuxième durée et pendant la deuxième durée et la troisième durée.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 et 2 sont respectivement une vue en coupe latérale et une vue de dessus, partielles et schématiques, d'un mode de réalisation d'un dispositif optoélectronique ;
la figure 3 est un schéma électrique équivalent d'un pixel d'affichage du dispositif optoélectronique représenté sur les figures 1 et 2 ;
les figures 4A et 4B sont des vues en coupe latérales, partielles et schématiques, d'autres modes de réalisation d'un dispositif optoélectronique ;
la figure 5 est un schéma électrique équivalent d'un pixel d'affichage du dispositif optoélectronique représenté sur la figure 4B ;
la figure 6 est une vue de dessus, partielle et schématique, du dispositif optoélectronique représenté sur les figures 1 et 2 illustrant un avantage du procédé de fabrication du dispositif optoélectronique ;
la figure 7 est un schéma illustrant la commande du dispositif optoélectronique représenté sur les figures 1 ou 4 ;
les figures 8A et 8B sont des vues de dessus, partielles et schématiques, d'autres modes de réalisation d'un dispositif optoélectronique ;
la figure 9 est une vue en coupe latérale, partielle et schématique, d'un autre mode de réalisation d'un dispositif optoélectronique ;
les figures 10 à 12 sont des vues de dessus, partielles et schématiques, d'autres modes de réalisation de dispositifs optoélectroniques ;
les figures 13 et 14 sont des chronogrammes respectivement des potentiels appliqués aux bandes conductrices reliées à un pixel d'affichage à commander et de la tension vue entre les bornes d'alimentation du pixel d'affichage à commander ;
la figure 15 représente un schéma électrique équivalent d'un mode de réalisation d'un pixel d'affichage ;
la figure 16 représente un schéma électrique équivalent d'une partie du pixel d'affichage de la figure 15 ;
la figure 17 représente un chronogramme de signaux lors du fonctionnement du pixel d'affichage de la figure 15 ;
les figures 18 à 21 représentent des schémas électriques équivalents de parties du pixel d'affichage de la figure 15 ;
la figure 22 représente un chronogramme de signaux lors du fonctionnement du pixel d'affichage dont le module de commande est selon le mode de réalisation représenté en figure 18 ;
la figure 23 représente un schéma électrique équivalent d'un autre mode de réalisation d'un pixel d'affichage ;
les figures 24 et 25 représentent des schémas électriques équivalents de parties du pixel d'affichage de la figure 23 ;
la figure 26 représente un chronogramme de signaux lors du fonctionnement du pixel d'affichage de la figure 23 ;
les figures 27A à 27I sont des vues en coupe latérales, partielles et schématiques, de structures obtenues à des étapes successives d'un mode de réalisation d'un procédé de fabrication du dispositif optoélectronique représenté sur les figures 1 et 2 ; et
les figures 28A à 28D sont des vues en coupe latérales, partielles et schématiques, de structures obtenues à des étapes successives d'un mode de réalisation d'un procédé de fabrication du dispositif optoélectronique représenté sur la figure 4B.

### Description détaillée

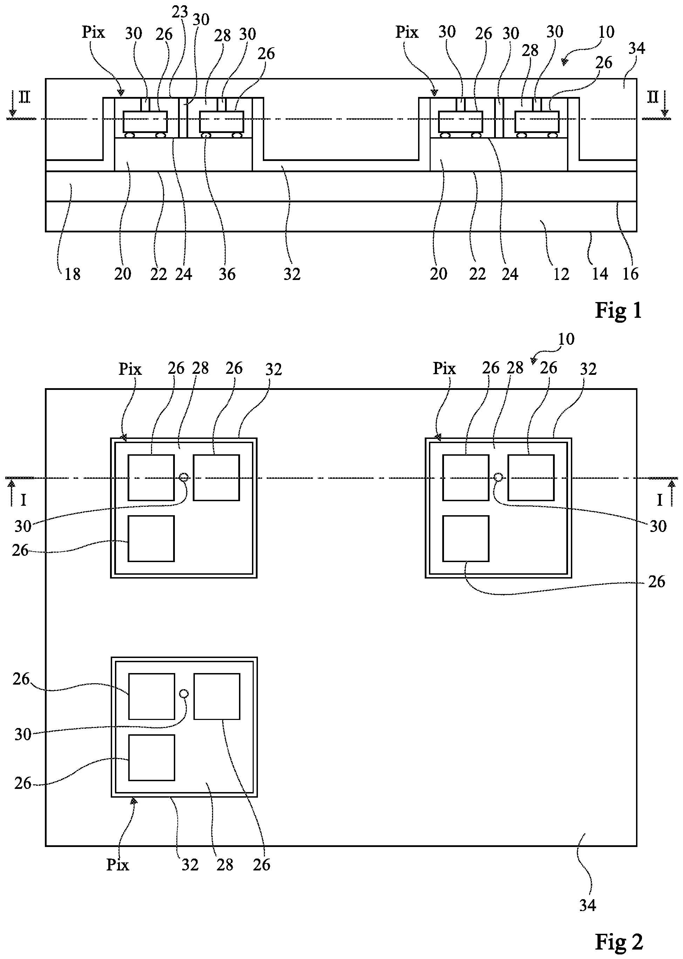

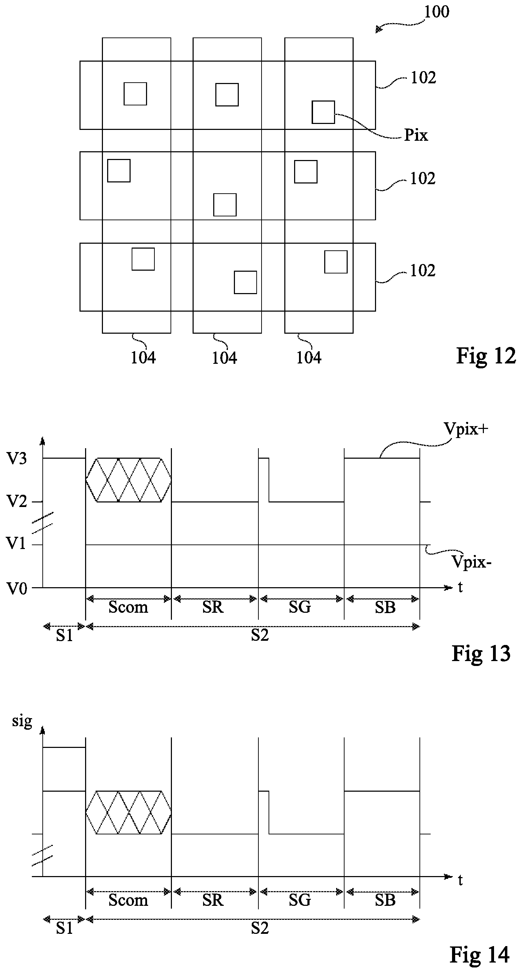

Les modes de réalisation correspondants aux figures 1-11 et 27A à 28D ne font pas partie de l'invention telle que revendiquée. L'invention est définie par les modes de réalisation des figures 12-26.

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, la structure d'une diode électroluminescente est bien connue de l'homme de l'art et n'est pas décrite en détail.

Dans la description qui suit, lorsque l'on fait référence à des qualificatifs de position relative, tels que les termes "dessus", "dessous", "supérieur", "inférieur", etc., il est fait référence à l'orientation des figures ou à un dispositif optoélectronique dans une position normale d'utilisation. Sauf indication contraire, les termes "sensiblement", "environ", "approximativement" et "de l'ordre de" signifient "à 10 % près", de préférence à 5 % près. En outre, on appelle "zone active" d'une diode électroluminescente la région de la diode électroluminescente depuis laquelle est émise la majorité du rayonnement électromagnétique fourni par la diode électroluminescente. De plus, on appelle "signal binaire" un signal qui alterne entre un premier état constant, par exemple un état bas, noté "0", et un deuxième état constant, par exemple un état haut, noté "1". Les états haut et bas de signaux binaires différents d'un même circuit électronique peuvent être différents. En pratique, les signaux binaires peuvent correspondre à des tensions ou à des courants qui peuvent ne pas être parfaitement constants à l'état haut ou bas.

Les figures 1 et 2 représentent un mode de réalisation d'un dispositif optoélectronique 10, par exemple correspondant à un écran d'affichage ou à un dispositif de projection d'images, comprenant des pixels d'affichage, deux pixels d'affichage étant représentés en figure 1 et trois pixels d'affichage étant représentés en figure 2. La figure 1 est une coupe de la figure 2 selon la ligne II-II et la figure 2 est une coupe de la figure 1 selon la ligne I-I.

Le dispositif 10 comprend du bas vers le haut en figure 1 :
un support 12 comprenant des faces inférieure et supérieure opposées 14, 16, de préférence parallèles ;
une première couche d'électrode 18 comprenant une couche conductrice électriquement 18 recouvrant la face supérieure 16 ;
des pixels d'affichage Pix, également appelés circuits de pixel d'affichage par la suite, reposant sur la couche d'électrode 18 et au contact de la couche d'électrode 18, chaque pixel d'affichage Pix comprenant :
   un circuit électronique 20, appelé circuit de commande par la suite, ayant des faces inférieure et supérieure opposées 22, 24 de préférence parallèles, la face inférieure 22 étant fixée à la couche d'électrode 18, éventuellement par l'intermédiaire d'un matériau de collage ;
   des circuits optoélectroniques 26 fixés à la face supérieure 24 du circuit électronique 20, trois circuits optoélectroniques 26 par pixel d'affichage Pix étant représentés en figure 2, chaque circuit optoélectronique 26 comprenant au moins une diode électroluminescente, non représentée ;
   une portion isolante électriquement 28 recouvrant les circuits optoélectroniques 26 et recouvrant la face supérieure 24 du circuit de commande 20 entre les circuits optoélectroniques 26 ;
   des éléments conducteurs électriquement 30 traversant la portion isolante 28, venant au contact des circuits optoélectroniques 26 et de la face supérieure 24 du circuit de commande 20 ;
   une couche isolante électriquement 32 recouvrant la couche d'électrode 18 entre les pixels d'affichage Pix et recouvrant les flancs latéraux des circuits électroniques 20 et éventuellement des portions isolantes 28 ; et
   une deuxième couche d'électrode 34 comprenant une couche conductrice électriquement au moins partiellement transparente aux rayonnements émis par les diodes électroluminescentes, la couche conductrice 34 recouvrant la couche isolante 32 et les portions isolantes 28 et étant au contact des éléments conducteurs 30 de chaque pixel d'affichage Pix.

Une couche d'encapsulation, non représentée, peut recouvrir la couche conductrice 34.

Lorsque la face inférieure 22 du circuit électronique 20 est fixée à la couche d'électrode 18 par un matériau de collage, le matériau de collage est de préférence conducteur électriquement. A titre de variante, un matériau de collage non conducteur électriquement peut être utilisé, par exemple disposé à la périphérie de la face inférieure 22 du circuit électronique 20.

Selon un mode de réalisation, chaque circuit optoélectronique 26 comprend au moins une diode électroluminescente. Dans le cas où le circuit optoélectronique 26 comprend deux ou plus de deux diodes électroluminescentes, toutes les diodes électroluminescentes du circuit optoélectronique 26 émettent de préférence un rayonnement lumineux sensiblement à la même longueur d'onde.

Chaque diode électroluminescente peut correspondre à une diode électroluminescente dite bidimensionnelle comprenant un empilement de couches semiconductrices sensiblement planes dont la zone active. Chaque diode électroluminescente peut comprendre au moins une diode électroluminescente tridimensionnelle à structure radiale comprenant une coque semiconductrice recouvrant un élément semiconducteur tridimensionnel, notamment un microfil, un nanofil, un cône, un tronc de cône, une pyramide ou une pyramide tronquée, la coque étant formée d'un empilement de couches semiconductrices non planes dont la zone active. Des exemples de telles diodes électroluminescentes sont décrits dans les demandes de brevet US2014/0077151 et US2016/0218240. Chaque diode électroluminescente peut comprendre au moins une diode électroluminescente tridimensionnelle à structure axiale dans laquelle la coque est située dans le prolongement axial de l'élément semiconducteur.

Pour chaque pixel d'affichage Pix, le circuit optoélectronique 26 peut être fixé au circuit de commande 20 par une liaison de type "Flip-Chip". Les éléments conducteurs fusibles 36, par exemple des billes de soudure ou des billes d'indium, qui relient le circuit optoélectronique 26 au circuit de commande 20 assurent la liaison mécanique entre le circuit optoélectronique 26 et le circuit de commande 20 et assurent, en outre, la connexion électrique de la diode électroluminescente ou des diodes électroluminescentes du circuit optoélectronique 26 au circuit de commande 20. Selon un autre mode de réalisation, chaque circuit optoélectronique 26 peut être fixé au circuit de commande 20 par collage direct.

Selon un mode de réalisation, chaque pixel d'affichage Pix comprend au moins deux types de circuits optoélectroniques 26. Le circuit optoélectronique 26 du premier type est adapté à émettre un premier rayonnement à une première longueur d'onde et le circuit optoélectronique 26 du deuxième type est adapté à émettre un deuxième rayonnement à une deuxième longueur d'onde. Selon un mode de réalisation, chaque pixel d'affichage Pix comprend au moins trois types de circuits optoélectroniques 26, le circuit optoélectronique 26 du troisième type étant adapté à émettre un troisième rayonnement à une troisième longueur d'onde. Les première, deuxième et troisième longueurs d'ondes peuvent être différentes.

Selon un mode de réalisation, la première longueur d'onde correspond à de la lumière bleue et est dans la plage de 430 nm à 490 nm. Selon un mode de réalisation, la deuxième longueur d'onde correspond à de la lumière verte et est dans la plage de 510 nm à 570 nm. Selon un mode de réalisation, la troisième longueur d'onde correspond à de la lumière rouge et est dans la plage de 600 nm à 720 nm.

Selon un mode de réalisation, chaque pixel d'affichage Pix comprend un circuit optoélectronique 26 d'un quatrième type, le circuit optoélectronique 26 du quatrième type étant adapté à émettre un quatrième rayonnement à une quatrième longueur d'onde. Les première, deuxième, troisième et quatrième longueurs d'ondes peuvent être différentes. Selon un mode de réalisation, la quatrième longueur d'onde correspond à de la lumière jaune et est dans la plage de 570 nm à 600 nm. Selon un autre mode de réalisation, le quatrième rayonnement correspond à un rayonnement dans le proche infrarouge, notamment à une longueur d'onde entre 700 nm et 980 nm, à un rayonnement ultraviolet, ou à de la lumière blanche.

Chaque circuit optoélectronique 26 peut comprendre un substrat semiconducteur sur lequel repose la diode électroluminescente ou les diodes électroluminescentes. Le substrat semiconducteur est, par exemple, un substrat en silicium, en germanium, en carbure de silicium, en un composé III-V, tel que du GaN ou du GaAs, un substrat en ZnO, ou un substrat en saphir. Selon un autre mode de réalisation, chaque circuit optoélectronique 26 peut ne pas comprendre de substrat. Une couche miroir peut alors être disposée sur la face inférieure du circuit optoélectronique 26 au contact de la diode électroluminescente ou des diodes électroluminescentes. Selon un mode de réalisation, la couche miroir est adaptée à réfléchir au moins en partie le rayonnement émis par les diodes électroluminescentes.

Chaque circuit de commande 20 peut comprendre des composants électroniques, non représentés, notamment des transistors, utilisés pour la commande des diodes électroluminescentes. Chaque circuit de commande 26 peut comprendre un substrat semiconducteur dans lequel et/ou sur lequel sont formés les composants électroniques. La face inférieure 22 du circuit de commande 20 peut alors correspondre à la face arrière du substrat opposée à la face avant du substrat du côté de laquelle sont formés les composants électroniques. Le substrat semiconducteur est, par exemple, un substrat en silicium, notamment en silicium monocristallin.

De préférence, les circuits optoélectroniques 26 comprennent seulement des diodes électroluminescentes et des éléments de connexion de ces diodes électroluminescentes et les circuits de commande 20 comprennent la totalité des composants électroniques nécessaires à la commande des diodes électroluminescentes des circuits optoélectroniques 26. A titre de variante, les circuits optoélectroniques 26 peuvent également comprendre d'autres composants électroniques en plus des diodes électroluminescentes.

Le dispositif optoélectronique 10 peut comprendre de 10 à 10⁹ pixels d'affichage Pix. Chaque pixel d'affichage Pix peut occuper en vue de dessus une surface comprise entre 1 µm² et 100 mm². L'épaisseur de chaque pixel d'affichage Pix peut être comprise entre 100 µm et 10 mm. L'épaisseur de chaque circuit électronique 20 peut être comprise entre 1 µm et 2000 µm. L'épaisseur de chaque circuit optoélectronique 26 peut être comprise entre 0,2 µm et 1000 µm.

Le support 12 peut être en un matériau isolant électriquement, comprenant par exemple un polymère, notamment une résine époxy, et en particulier le matériau FR4 utilisé pour la fabrication de circuits imprimés, ou en un matériau métallique, par exemple de l'aluminium. L'épaisseur du support 12 peut être comprise entre 100 µm et 10 mm.

La couche conductrice 18 correspond, de préférence à une couche métallique, par exemple en aluminium, en argent, en cuivre ou en zinc. L'épaisseur de la couche conductrice 18 peut être comprise entre 0,5 µm et 1000 µm.

Chaque portion isolante 28 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (SiOₓN_{y} où x peut être environ égal à 1/2 et y peut être environ égal à 1, par exemple du Si₂ON₂), en oxyde d'aluminium (Al₂O₃), ou en oxyde d'hafnium (HfO₂). L'épaisseur maximale de chaque portion isolante 28 peut être comprise entre 0,5 µm et 1000 µm.

Chaque élément conducteur 30 peut être en un matériau choisi dans le groupe comprenant le cuivre, le titane, le nickel, l'or, l'étain, l'aluminium et les alliages d'au moins deux de ces composés.

La couche isolante 32 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (SiOₓN_{y} où x peut être environ égal à 1/2 et y peut être environ égal à 1, par exemple du Si₂ON₂), en oxyde d'aluminium (Al₂O₃), ou en oxyde d'hafnium (HfO₂). L'épaisseur de la couche isolante 32 peut être comprise entre 0,02 µm et 1000 µm. De préférence, la couche isolante 32 est opaque. La couche isolante 32 peut correspondre à une résine blanche, à une résine noire ou à une résine transparente chargée, notamment en particules de titane.

La couche conductrice 34 est adaptée à laisser passer le rayonnement électromagnétique émis par les diodes électroluminescentes. Le matériau formant la couche conductrice 34 peut être un matériau transparent et conducteur tel que de l'oxyde d'indium-étain (ou ITO, acronyme anglais pour Indium Tin Oxide), de l'oxyde de zinc dopé à l'aluminium ou au gallium, ou du graphène. L'épaisseur minimale de la couche conductrice électriquement 34 sur les pixels d'affichage Pix peut être comprise entre 0,1 µm et 1000 µm.

La couche d'encapsulation peut être réalisée en un matériau isolant au moins partiellement transparent. La couche d'encapsulation peut être réalisée en un matériau inorganique au moins partiellement transparent. A titre d'exemple, le matériau inorganique est choisi parmi le groupe comprenant les oxydes de silicium du type SiOₓ où x est un nombre réel compris entre 1 et 2 ou SiO_{y}N_{z} où y et z sont des nombres réels compris entre 0 et 1 et les oxydes d'aluminium, par exemple Al₂O₃. La couche d'encapsulation peut être réalisée en un matériau organique au moins partiellement transparent. A titre d'exemple, la couche d'encapsulation est un polymère silicone, un polymère époxyde, un polymère acrylique ou un polycarbonate.

Selon un mode de réalisation, en fonctionnement, une tension V_{E} est appliquée entre les couches d'électrode 34 et 18 pour l'alimentation des pixels d'affichage Pix, notamment des diodes électroluminescentes des circuits optoélectroniques 26 des pixels d'affichage Pix.

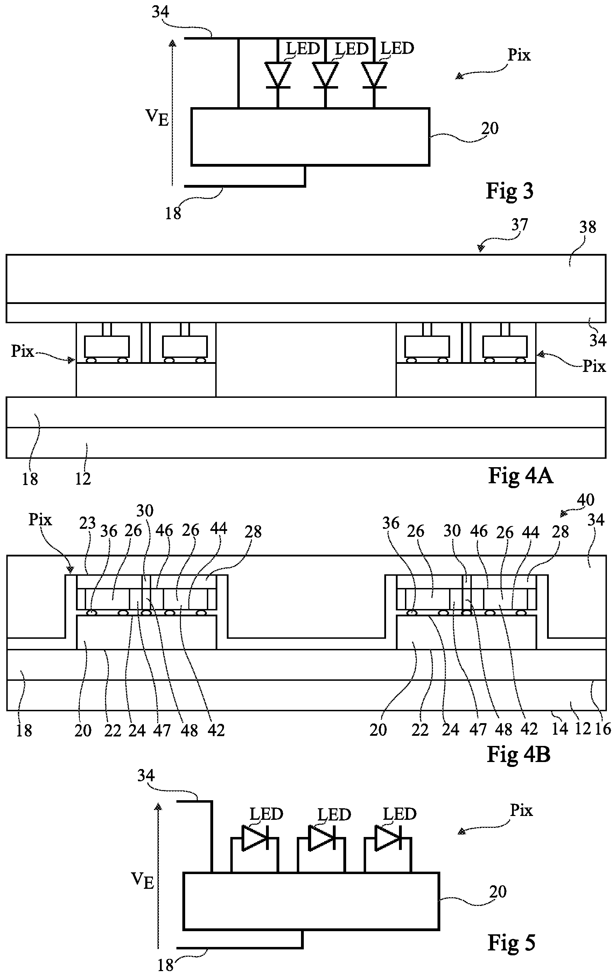

La figure 3 représente un schéma électrique équivalent du pixel d'affichage Pix représenté sur les figures 1 et 2. Une première électrode, par exemple la cathode, de chaque diode électroluminescente LED est connectée au circuit de commande 20 du pixel d'affichage Pix tandis que la deuxième électrode de chaque diode électroluminescente LED, par exemple l'anode, est connectée à la couche d'électrode 34. Le circuit de commande 20 est connecté entre les couches d'électrode 18 et 34 et reçoit la tension V_{E}. Le circuit 20 commande les diodes électroluminescentes des circuits optoélectroniques 26.

La figure 4A est une vue analogue à la figure 1 d'un autre mode de réalisation d'un dispositif optoélectronique 37 comprenant l'ensemble des éléments du dispositif optoélectronique 10 à la différence que la couche isolante 32 n'est pas présente et que la couche d'électrode 34 repose sur un substrat 38. Un procédé de fabrication du dispositif optoélectronique 37 comprend la formation de la couche d'électrode 18 sur le support 12, l'assemblage des pixels d'affichage Pix sur la couche d'électrode 18, la formation de la couche d'électrode 34 sur le substrat 38 puis l'hybridation des pixels d'affichage Pix sur la couche d'électrode 34. Le support 12 et le substrat 38 peuvent être flexibles, ce qui permet la fabrication d'un dispositif optoélectronique 37 flexible.

La figure 4B est une vue analogue à la figure 1 d'un autre mode de réalisation d'un dispositif optoélectronique 40 comprenant l'ensemble des éléments du dispositif optoélectronique 10 à la différence que, pour chaque pixel d'affichage Pix, les circuits optoélectroniques 26 sont intégrés dans un circuit optoélectronique 42 unique recouvrant la face supérieure 24 du circuit de commande 20 du pixel d'affichage Pix et fixé à la face supérieure 24 du circuit de commande 20, par exemple par les éléments conducteurs fusibles 36. Chaque circuit optoélectronique 42 comprend des faces inférieure et supérieure opposées 44, 46, de préférence parallèles, la face inférieure 44 du circuit optoélectronique 42 étant fixée à la face supérieure 24 du circuit de commande 20. Le circuit optoélectronique 42 comprend au moins une connexion verticale traversante 48 ou TSV (acronyme anglais pour Through Silicon Via) formée par exemple dans une portion 47 du circuit optoélectronique 42, qui relie la face supérieure 46 à la face inférieure 44 et qui est isolée électriquement du reste du circuit optoélectronique 42. La portion 47 peut être en un matériau isolant électriquement ou en un matériau semiconducteur. Dans ce dernier cas, le TSV 48 est entouré d'une couche isolante électriquement. La face supérieure 46 de chaque circuit optoélectronique 42 est recouverte par la portion isolante 28. La portion isolante 28 est traversée par un élément conducteur électriquement 30 qui est en contact avec le TSV 48. Selon un autre mode de réalisation, l'alimentation du circuit de commande 20 est réalisée par un autre moyen que le TSV 48.

Selon un mode de réalisation, chaque TSV 48 peut comprendre un coeur en un matériau conducteur électriquement, par exemple du silicium polycristallin, du tungstène, du cuivre, de l'aluminium ou un matériau métallique réfractaire, entouré d'une couche isolante électriquement.

Chaque circuit optoélectronique 42 comprend au moins une première diode électroluminescente adaptée à émettre le premier rayonnement à la première longueur d'onde et une deuxième diode électroluminescente adaptée à émettre le deuxième rayonnement à la deuxième longueur d'onde. Chaque circuit optoélectronique 42 peut en outre comprendre au moins une troisième diode électroluminescente adaptée à émettre le troisième rayonnement à la troisième longueur d'onde.

La figure 5 représente un schéma électrique équivalent du pixel d'affichage Pix représenté sur la figure 3 dans le cas où chaque circuit optoélectronique 42 comprend trois diodes électroluminescentes. Dans ce mode de réalisation, les deux électrodes de chaque diode électroluminescente LED du circuit optoélectronique 42 sont connectées au circuit de commande 20 du pixel d'affichage Pix. Le circuit de commande 20 est connecté entre les couches d'électrode 18 et 34 et reçoit la tension V_{E}. Le circuit 20 commande les diodes électroluminescentes LED du circuit optoélectronique 26.

Dans le présent mode de réalisation, la couche conductrice 18 est en contact avec tous les pixels d'affichage Pix du dispositif optoélectronique 10, 40 et la couche conductrice 34 est en contact avec tous les pixels d'affichage Pix du dispositif optoélectronique 10, 40.

Un mode de réalisation d'un procédé de fabrication du dispositif optoélectronique 10 ou 40 comprend la fabrication des pixels d'affichage Pix et la mise en place séparément de chaque pixel d'affichage Pix sur la couche d'électrode 18. Selon un mode de réalisation, les couches d'électrode 18 et 34 étant communes à tous les pixels d'affichage Pix, la connexion des pixels d'affichage Pix est simplifiée et il n'est pas nécessaire que le placement de chaque pixel d'affichage Pix sur la couche d'électrode 18 soit réalisé avec une précision élevée. Ceci permet de façon avantageuse de mettre en oeuvre des techniques plus rapides et à coûts réduits pour disposer les pixels d'affichage Pix sur la couche d'électrode 18. En outre, comme les diodes électroluminescentes sont assemblées au préalable sur le circuit électronique 20 du pixel d'affichage Pix, le nombre de transferts à réaliser lors du montage du dispositif optoélectronique 10 ou 40 est réduit. Dans le présent mode de réalisation, chaque pixel d'affichage Pix peut comprendre une mémoire dans laquelle est stocké un identifiant du pixel. Le procédé de fabrication peut comprendre une phase d'étalonnage dans laquelle la position de chaque pixel d'affichage Pix est récupérée en fonction de son identifiant. En fonctionnement, des données peuvent alors être transmises aux pixels en fonction de leur identifiant.

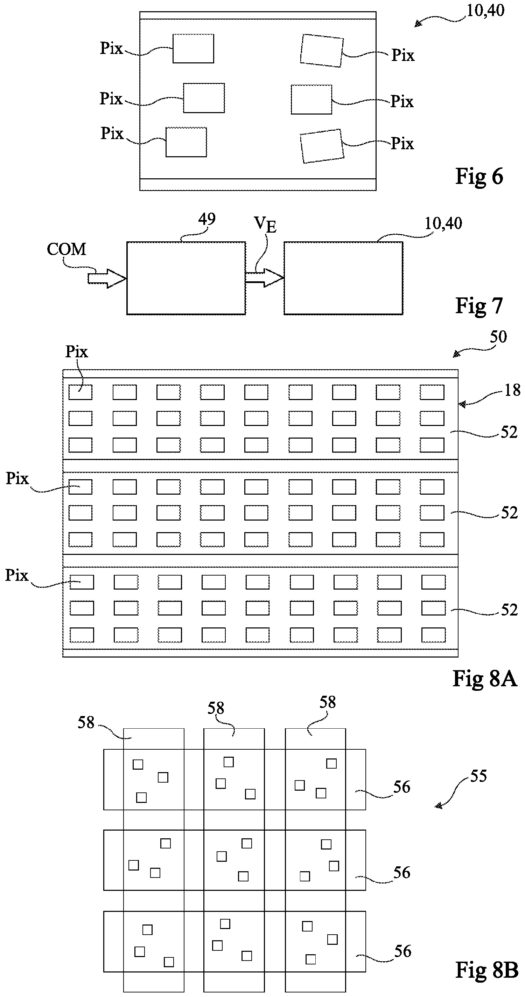

La figure 6 représente une vue de dessus schématique du dispositif optoélectronique 10 ou 40 illustrant le fait que les pixels d'affichage Pix peuvent ne pas être disposés de façon très précise, par exemple parfaitement alignés en rangées et en colonnes, et que certains pixels d'affichage Pix peuvent être inclinés par rapport aux directions des rangées et des colonnes.

Dans les modes de réalisation décrits précédemment, la couche d'électrode 18 est connectée à tous les pixels d'affichage Pix et se présente sous la forme d'une couche ininterrompue s'étendant sur la majorité, voire la totalité du support 12.

Pour chaque pixel d'affichage Pix, le circuit de commande 20 est adapté à recevoir des signaux de commande et à commander, à partir des signaux de commande reçus, les diodes électroluminescentes du pixel d'affichage, notamment la teinte, la saturation et la luminosité de la lumière émise par le pixel d'affichage.

Selon un mode de réalisation, les signaux de commande peuvent être transmis aux circuits de commande 20 des pixels d'affichage Pix par une modulation de la tension V_{E}.

La figure 7 représente de façon très schématique un module de traitement 49 recevant des signaux de commande COM et adapté à fournir au dispositif optoélectronique 10 ou 40 une tension V_{E} d'alimentation des pixels d'affichage Pix qui est modulée avec les signaux de commande COM. Le module de traitement 49 peut correspondre à un circuit dédié ou peut comprendre un processeur, par exemple un microprocesseur ou un microcontrôleur, adapté à exécuter des instructions d'un programme d'ordinateur stocké dans une mémoire.

Le circuit de commande 20 de chaque pixel d'affichage Pix peut extraire les signaux de commande COM par démodulation de la tension V_{E}. Le circuit de commande 20 peut alors déterminer si les signaux de commande COM lui sont destinés. A titre d'exemple, un identifiant peut être associé à chaque pixel d'affichage Pix et les signaux de commande COM obtenus par démodulation de la tension V_{E} peuvent comprendre l'identifiant du pixel d'affichage auquel ces signaux de commande sont destinés.

De façon avantageuse, un adressage actif des pixels d'affichage Pix peut être réalisé. En effet, chaque circuit de commande 20 peut commander le maintien des propriétés d'affichage, notamment la teinte, la saturation et la luminosité, du pixel d'affichage jusqu'à ce qu'il reçoive de nouveaux signaux de commande.

La figure 8A représente une vue de dessus schématique d'un autre mode de réalisation d'un dispositif optoélectronique 50 comprenant l'ensemble des éléments du dispositif optoélectronique 10 ou 40 dans lequel la couche d'électrode 18 est divisée en bandes conductrices électriquement 52 parallèles s'étendant sur le support 12, trois bandes 52 étant représentées à titre d'exemple sur la figure 8. Au moins une rangée de pixels d'affichage Pix est répartie sur chaque bande conductrice. De préférence, plusieurs rangées de pixels d'affichage Pix sont réparties sur chaque bande conductrice 52, trois rangées de pixels d'affichage Pix étant représentées par bande conductrice 52 à titre d'exemple sur la figure 8.

Selon un autre mode de réalisation, la couche d'électrode 18 et/ou la couche d'électrode 34 peut être divisée en portions d'électrode distinctes. Selon un autre mode de réalisation, la couche d'électrode 34 peut également être divisée en bandes parallèles et conductrices électriquement. Lorsque les couches d'électrode 18 et 34 sont chacune divisées en bandes, les bandes de la couche d'électrode 18 ont de préférence sensiblement les mêmes dimensions que les bandes de la couche d'électrode 34 et chaque bande de la couche d'électrode 34 recouvre sensiblement une seule des bandes de la couche d'électrode 18. Selon un autre mode de réalisation, l'une des électrodes 18 ou 34 peut être commune aux pixels d'affichage Pix tandis que l'autre électrode 18 ou 34 est divisée en bandes parallèles et conductrices électriquement.

Dans le mode de réalisation dans lequel les couches d'électrode 18, 34 sont divisées en bandes superposées prenant en sandwich des ensembles de pixels d'affichage, différents signaux de commande peuvent être transmis en parallèle en modulant différemment la tension V_{E} pour chaque ensemble de pixels d'affichage. Ceci permet de transmettre en parallèle les signaux de commande pour chaque ensemble de pixels d'affichage Pix. Ceci permet de réduire la fréquence de modulation du rayonnement électromagnétique et/ou d'augmenter le débit de données transmises.

La figure 8B est une vue de dessus partielle et schématique d'un autre mode de réalisation d'un dispositif optoélectronique 55 dans lequel la couche d'électrode 18 est divisée en bandes conductrices 56 s'étendant selon la direction des rangées et dans lequel la couche d'électrode 34 est divisée en bandes conductrices 58 s'étendant selon la direction des colonnes, et appelées électrodes de colonne. Au moins un pixel d'affichage Pix est disposé à l'intersection, en vue de dessus, entre chaque électrode de rangée 56 et chaque électrode de colonne 58 et est connecté à l'électrode de rangée 56 et à l'électrode de colonne 58. A titre d'exemple, en figure 8B, trois pixels d'affichage Pix sont prévus à l'intersection, en vue de dessus, entre chaque électrode de rangée 56 et chaque électrode de colonne 58 et forment un pixel de l'image à afficher. Lorsque plusieurs pixels d'affichage Pix sont prévus pour chaque pixel de l'image à afficher, ceci permet d'avoir une redondance au cas où l'un des pixels d'affichage Pix est défectueux.

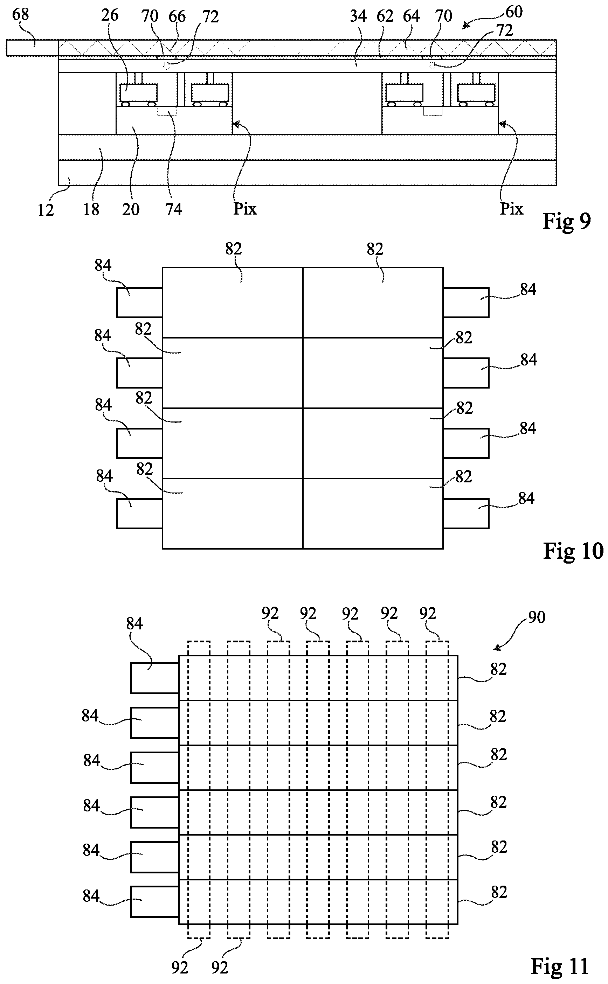

La figure 9 est une vue analogue à la figure 1 d'un autre mode de réalisation d'un dispositif optoélectronique 60 comprenant l'ensemble des éléments du dispositif optoélectronique 10 et comprenant, en outre, un empilement d'une première couche 62 et d'une deuxième couche 64 recouvrant la couche d'électrode 34. La couche 62 est composée d'un matériau dont l'indice de réfraction est supérieur à l'indice de réfraction du matériau composant la couche 64. Les couches 62 et 64 sont au moins partiellement transparentes aux rayonnements émis par les pixels d'affichage Pix. La couche 64 est par exemple en verre, en SiO₂, en Al₂O₃, en HfO₂, en un matériau organique, par exemple un polymère, notamment le poly(méthacrylate de méthyle) (PMMA). La couche 62 correspond par exemple à un film d'air. La couche 64 forme un guide d'onde pour un rayonnement électromagnétique 66, par exemple dans le domaine visible ou hors du domaine visible, de préférence dans une plage de longueur d'onde entre le domaine infrarouge et ultraviolet. Le dispositif optoélectronique 60 comprend un circuit optoélectronique 68 adapté à émettre un tel rayonnement 66 dans la couche 64. Le circuit optoélectronique 68 peut être situé à la périphérie de la couche 64 et émettre le rayonnement 66 dans la couche 64 depuis le bord latéral de celle-ci. Le rayonnement infrarouge est modulé pour transporter les signaux de commande décrits précédemment. Selon un mode de réalisation, il est prévu un moyen de couplage 70 optique entre chaque pixel d'affichage Pix et le guide d'onde 64 de sorte qu'une fraction 72 du rayonnement 66 guidé dans le guide d'onde 64 s'échappe au niveau de chaque pixel d'affichage Pix via le moyen de couplage 70. A titre d'exemple, le moyen de couplage 70 correspond à une texturation prévue sur la couche 64 et/ou sur la couche 62 en vis-à-vis de chaque pixel d'affichage Pix pour assurer le couplage optique entre chaque pixel d'affichage Pix et la couche 64. Le moyen de couplage 70 correspond, par exemple, à un réseau de diffraction permettant de renvoyer une partie de la lumière se propageant dans le guide d'onde 64 vers le pixel d'affichage Pix associé.

Chaque pixel d'affichage Pix comprend au moins un capteur 74 adapté à détecter le rayonnement émis par le circuit optoélectronique 68, par exemple une photodiode ou une photorésistance, le capteur fournissant au circuit de commande 20 un signal électrique représentatif par exemple de l'intensité du rayonnement 72 reçu par le pixel d'affichage Pix. Le circuit de commande 20 est connecté au capteur et est adapté à extraire les signaux de commande à partir du signal de mesure fourni par le capteur.

Selon un mode de réalisation, le même rayonnement électromagnétique transportant les signaux de commande est transmis à tous les pixels d'affichage Pix. Selon un autre mode de réalisation, plusieurs guides d'onde peuvent être prévus, chaque guide d'onde étant associé à un ensemble de pixels d'affichage. Selon un autre mode de réalisation des zones de rupture optique peuvent être réalisées dans le guide d'onde pour pouvoir adresser différents groupes de pixels.

La figure 10 est une vue de dessus partielle et schématique d'un autre mode de réalisation d'un dispositif optoélectronique 80 comprenant des guides d'onde disjoints 82, ou un seul guide d'onde ayant des discontinuités optiques, recouvrant chacun un ensemble de pixels d'affichage, non représentés. Le dispositif optoélectronique 80 comprend, en outre, des circuits optoélectroniques 84 adaptés chacun à émettre dans le guide d'onde 82 associé un rayonnement électromagnétique dans le domaine non visible. Ceci permet de transmettre en parallèle les signaux de commande pour chaque ensemble de pixels d'affichage Pix. Ceci permet de réduire la fréquence de modulation du rayonnement électromagnétique et/ou d'augmenter le débit de données transmises.

La figure 11 est une vue de dessus partielle et schématique d'un autre mode de réalisation d'un dispositif optoélectronique 90 comprenant l'ensemble des éléments du dispositif 80, chaque guide d'onde disjoint 82 recouvrant au moins une rangée de pixels d'affichage.

Dans le présent mode de réalisation, la couche d'électrode 34 ou la couche d'électrode 18 est divisée en bandes conductrices 92 s'étendant selon la direction des colonnes. Chaque bande conductrice 92 est reliée aux pixels d'affichage d'au moins une colonne de pixels.

Un mode de réalisation d'un procédé de commande des pixels d'affichage comprend une phase de sélection d'un pixel d'affichage ou d'un groupe de pixels d'affichage par l'intermédiaire des électrodes 18, 92 suivie d'une phase de transmission de données à certains des pixels d'affichage sélectionnés par l'un des guides d'onde 82. La phase de sélection peut être réalisée en amenant la bande conductrice 92 reliée aux pixels d'affichage à sélectionner à un premier potentiel tandis que les autres bandes conductrices 92 sont maintenues à un deuxième potentiel différent du premier potentiel. Seuls les pixels d'affichage qui sont sélectionnés sont actifs et sont adaptés à traiter des données transmises par un rayonnement électromagnétique. Les autres pixels d'affichage sont inactifs et ignorent les données qui sont transmises par le rayonnement. Le rayonnement transportant les données est alors émis dans le guide d'onde 82 qui recouvre les pixels d'affichage d'intérêt. Seuls les pixels d'affichage qui ont été sélectionnés et qui sont recouverts par le guide d'onde 82 vont traiter les données obtenues par la détection du rayonnement transmis par le guide d'onde 82.

Selon un mode de réalisation, chaque bande conductrice 92 est reliée aux pixels d'affichage d'une seule colonne de pixels d'affichage et chaque guide d'onde 82 recouvre seulement une rangée de pixels d'affichage. Le procédé de commande décrit précédemment permet alors de ne sélectionner et transmettre des données qu'à un seul pixel d'affichage.

La figure 12 est une vue de dessus partielle et schématique d'un mode de réalisation d'un dispositif optoélectronique 100 selon l'invention dans lequel la couche d'électrode 18 est divisée en bandes conductrices 102 s'étendant selon la direction des rangées, et appelées électrodes de rangée, chaque bande conductrice 102 étant reliée aux pixels d'affichage Pix d'une rangée de pixels et dans lequel la couche d'électrode 34 est divisée en bandes conductrices 104 s'étendant selon la direction des colonnes, et appelées électrodes de colonne, chaque bande conductrice 104 étant reliée aux pixels d'affichage Pix d'une colonne de pixels.

Comme cela apparaît sur la figure 12, la largeur de chaque bande conductrice 102 est supérieure à la dimension du pixel d'affichage Pix mesurée selon la direction des colonnes et la largeur de chaque bande conductrice 104 est supérieure à la dimension du pixel d'affichage Pix mesurée selon la direction des rangées. De ce fait, pour chaque rangée, les pixels d'affichage Pix appartenant à la rangée peuvent ne pas être parfaitement alignés. De même, pour chaque colonne, les pixels d'affichage Pix appartenant à la colonne peuvent ne pas être parfaitement alignés.

Un mode de réalisation d'un procédé de commande d'un pixel d'affichage Pix selon l'invention comprend une phase de sélection du pixel d'affichage suivie d'une phase de transmission de données au pixel d'affichage Pix.

La figure 13 est un chronogramme respectivement des potentiels Vpix+ et Vpix- appliqués respectivement aux électrodes de colonne et de rangée reliées à un pixel d'affichage à commander et la figure 14 est un chronogramme de la tension sig vue entre les bornes d'alimentation du pixel d'affichage à commander.

Selon l'invention, le circuit optoélectronique 100 est adapté à faire varier le potentiel de chaque électrode de rangée entre deux valeurs V0 et V1, V1 étant supérieur strictement à V0, et à faire varier le potentiel de chaque électrode de colonne entre deux valeurs V2 et V3, V3 étant supérieur strictement à V2 et V2 étant supérieur strictement à V1. La différence entre V3 et V2 peut être égale à la différence entre V1 et V0.

Selon l'invention, le procédé de commande comprend une phase S1 de sélection d'un pixel d'affichage à commander suivie d'une phase S2 de transmission de données au pixel d'affichage sélectionné.

La phase S1 consiste à amener l'électrode de rangée reliée au pixel d'affichage à commander à V0, les autres électrodes de rangée étant laissées à V1 et à amener l'électrode de colonne reliée au pixel d'affichage à commander à V3, les autres électrodes de rangée étant laissées à V2. Le pixel d'affichage à commander voit alors une tension égale à V3-V0, tandis que les autres pixels d'affichage de la même rangée voient une tension égale à V2-V0, que les autres pixels d'affichage de la même colonne voient une tension égale à V3-V1 et que les autres pixels d'affichage des autres rangées et colonnes voient une tension égale à V2-V1. Tous les pixels d'affichage autres que le pixel d'affichage à commander voient une tension inférieure à V3-V0.

La phase S2 consiste à faire varier le potentiel de l'électrode de colonne du pixel d'affichage à commander entre V2 et V3 tout en laissant l'électrode de rangée du pixel d'affichage à commander à V1. De ce fait, la tension vue par le pixel d'affichage à commander varie comme le potentiel de l'électrode de colonne.

Chaque pixel d'affichage est adapté à détecter si, à la phase S1, la tension d'alimentation qui lui est appliquée est supérieure à un seuil. Lorsqu'un pixel d'affichage détecte que, à la phase S1, la tension d'alimentation qui lui est appliquée est supérieure au seuil, il est adapté à traiter les données qui sont ensuite transmises pendant la phase S2. Lorsqu'un pixel d'affichage détecte que, à la phase S1, la tension d'alimentation qui lui est appliquée est inférieure au seuil, il ne traite pas les données qui lui sont ensuite transmises pendant la phase S2.

Le présent mode de réalisation permet de sélectionner un pixel d'affichage tout en maintenant l'alimentation des autres pixels d'affichage. Le présent mode de réalisation permet en outre de transmettre des données à un seul pixel d'affichage d'une matrice de pixels d'affichage. De façon avantageuse, tous les pixels d'affichage de la matrice peuvent correspondre à des dispositifs optoélectroniques identiques. Ceci permet de simplifier la conception des pixels d'affichage et le montage des pixels d'affichage. Le présent mode de réalisation permet en outre de transmettre des données simultanément à plusieurs pixels d'affichage, voire de transmettre des données simultanément à tous les pixels d'affichage. En outre, le fait que le potentiel de l'une des électrodes reste constant pendant la phase S2 permet avantageusement que le pixel d'affichage ait une référence de potentiel constante pendant la phase S2, ce qui simplifie le traitement des signaux par le pixel d'affichage.

Les données transmises pendant la phase S2 peuvent être des données binaires et/ou des données analogiques. Les données transmises peuvent être modulées. Il peut s'agir d'une modulation en fréquence, en amplitude, en phase, ou une modulation en largeur d'impulsion.

A titre d'exemple, sur les figures 13 et 14, la phase S2 comprend successivement une sous-phase Scom correspondant à la transmission de données binaires, une phase SR correspondant à la transmission d'une commande pour un premier sous-pixel d'affichage, par exemple le sous-pixel d'affichage rouge, une phase SG correspondant à la transmission d'une commande pour un deuxième sous-pixel d'affichage, par exemple le sous-pixel d'affichage vert et une phase SB correspondant à la transmission d'une commande pour un troisième sous-pixel d'affichage, par exemple le sous-pixel d'affichage bleu. A titre de variante, la sous-phase Scom peut ne pas être présente.

Selon un mode de réalisation, chaque sous-phase SR, SG et SB comprend la transmission d'une impulsion de tension dont la durée est représentative de la durée souhaitée d'activation du sous-pixel d'affichage considéré.

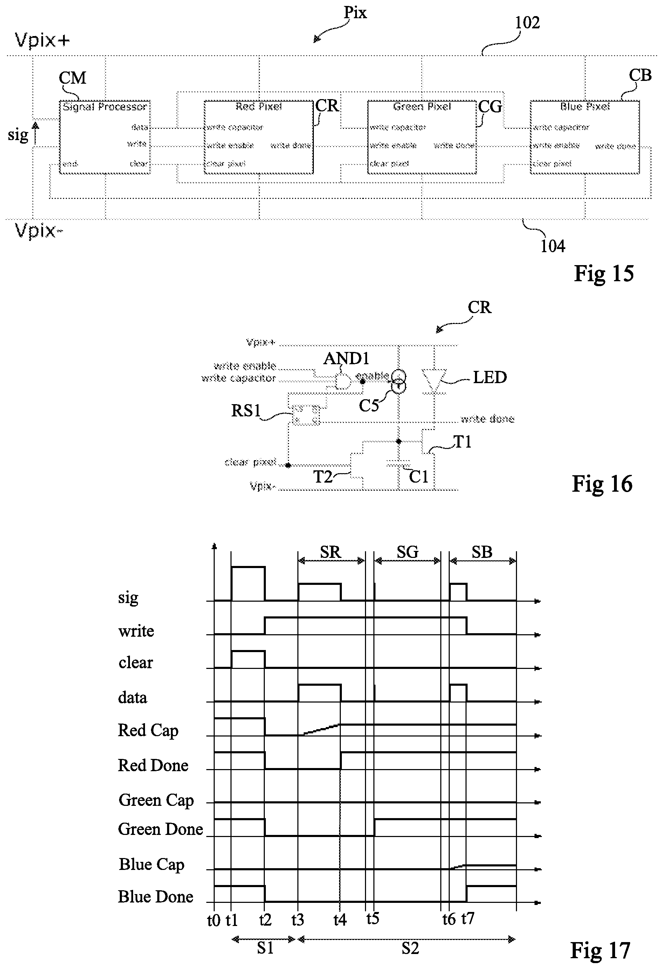

La figure 15 représente un schéma électrique équivalent d'un mode de réalisation du pixel d'affichage Pix.

Le pixel d'affichage Pix est relié à l'une des électrodes de colonne 104 qui est au potentiel Vpix+ et à l'une des électrodes de rangée 102 qui est au potentiel Vpix-.

Le pixel d'affichage Pix comprend un module de traitement CM (Signal Processor), un module CR de commande d'un premier sous-pixel d'affichage (Red Pixel), par exemple du sous-pixel d'affichage rouge, un module CG de commande d'un deuxième sous-pixel d'affichage (Green Pixel), par exemple du sous-pixel d'affichage vert, et un module CB de commande d'un troisième sous-pixel d'affichage (Blue Pixel), par exemple du sous-pixel d'affichage bleu. Les composants électroniques du module de traitement CM sont situés au niveau du circuit de commande 20. Les composants électroniques des modules CR, CG, CB peuvent être situés au niveau du circuit de commande 20 et/ou au niveau des circuits optoélectroniques 26.

Chaque module CM, CR, CG et CB est relié aux électrodes de colonne et de rangée 102, 104 associées aux potentiels Vpix+ et Vpix- pour leur alimentation électrique. Le circuit de commande CM reçoit les valeurs de potentiel Vpix+ et Vpix- et un signal end comme signaux d'entrée et fournit trois signaux binaires data, write et clear. Selon un mode de réalisation, les modules CR, CG et CB sont identiques et chaque module CR, CG et CB comprend trois entrées write capacitor, write enable et clear pixel et une sortie write done. A titre de variante, le module CB peut être différent des modules CR et CG et ne pas comprendre de sortie write done. Les entrées write capacitor de chaque module CR, CG et CB reçoivent chacune le signal data. Les entrées clear pixel de chaque module CR, CG et CB reçoivent chacune le signal clear. L'entrée write enable du module CR reçoit le signal write. L'entrée write enable du module CG est reliée à la sortie write done du module CR et l'entrée write enable du module CB est reliée à la sortie write done du module CG. Dans le mode de réalisation illustré en figure 15, la sortie write done du module CB fournit le signal end reçu par le module CM.

La figure 16 représente un schéma électrique équivalent d'un mode de réalisation du module CR, les modules CG et CB pouvant être identiques.

Selon un mode de réalisation, le module CR comprend une diode électroluminescente LED dont l'anode est reliée à l'électrode au potentiel Vpix+ et dont la cathode est reliée à une borne de commande parmi le drain ou la source d'un transistor MOS T1 et dont l'autre borne de commande est reliée à l'électrode au potentiel Vpix-. Le module CR comprend, en outre, un condensateur C1 dont une électrode est reliée à la grille du transistor T1 et dont l'autre électrode est reliée à l'électrode au potentiel Vpix-. Le module CR comprend, en outre, un transistor MOS T2 dont une borne de commande parmi le drain ou la source est reliée à la grille du transistor T1 et dont l'autre borne de commande est reliée à l'électrode au potentiel Vpix-. La grille du transistor T2 est reliée à l'entrée clear pixel. Le module CR comprend, en outre, une porte logique ET à trois entrées AND1 dont deux entrées correspondent aux entrées write enable et write capacitor du module CR. La porte logique AND1 fournit un signal enable de commande à une source de courant CS dont une borne est reliée à l'électrode au potentiel Vpix+ et dont l'autre borne est reliée à la grille du transistor T1. Le module CR comprend, en outre, une bascule RS RS1 dont l'entrée S, sensible aux fronts descendants, reçoit le signal enable, dont l'entrée R est reliée à l'entrée clear pixel du module CR et dont la sortie Q̅ est reliée à la troisième entrée de la porte logique AND1. La sortie Q de la bascule RS1 est reliée à la sortie write done du module CR. En fonctionnement, l'intensité du courant traversant la diode électroluminescente LED dépend de la conduction du transistor T1 qui est fixée par la tension aux bornes du condensateur C1. Plus la tension aux bornes du condensateur C1 est élevée et plus le transistor T1 est passant.

La figure 17 représente un chronogramme de signaux lors d'un cycle de commande du pixel d'affichage de la figure 15. On appelle t0, t1, t2, t3, t4, t5, t6 et t7 des instants successifs. La sortie write enable du module CR fournit le signal Red Done. La sortie write enable du module CG fournit le signal Green Done. La sortie write enable du module CB fournit le signal Blue Done.

Les signaux Red Cap, Green Cap et Blue Cap correspondent respectivement aux tensions aux bornes des condensateurs C1 respectivement des modules CR, CG et CB. Le signal sig correspond à la différence entre les potentiels Vpix+ et Vpix-. Le signal sig peut prendre trois valeurs discrètes "0", "1" et "2".

Dans le présent mode de réalisation, le signal data est égal au signal sig en dehors de la phase de sélection et le signal write est mis à "1" pendant les phases de commande des sous-pixels d'affichage.

A l'instant t0, les signaux Red Done, Green Done et Blue Done sont à "1", le signal sig est à "0" et le signal clear est à "0". A l'instant t1, le signal sig passe de "0" à "2". Le module CM détecte que le pixel d'affichage est sélectionné et met le signal clear à "1". A l'instant t2, le signal sig passe à "0". Le module CM met alors le signal write à "1" et le signal clear à "0". Ceci initialise les bascules RS1 des modules CR, CG et CB, met les signaux Red Done, Green Done et Blue Done à "0" et vide les condensateurs C1 des modules CR, CG et CB, mettant les tensions Red Cap, Green Cap et Blue Cap à 0. A l'instant t3, la phase de commande du sous-pixel d'affichage rouge commence. Dans le présent mode de réalisation, le sous-pixel d'affichage rouge est activé et le signal sig passe à "1". Le signal data est égal au signal sig de sorte que le condensateur C1 du module CR est chargé par la source de courant CS jusqu'à l'instant t4 auquel les signaux sig et data passent à "0". Le signal Red Done passe alors à "1". A l'instant t5, la phase de commande du sous-pixel d'affichage vert commence. Dans le présent mode de réalisation, le sous-pixel d'affichage vert n'est pas activé et le signal sig passe à "1" pendant une durée très brève. Le condensateur C1 du module CG n'est alors sensiblement pas chargé et le signal Green Done passe alors à "1". A l'instant t6, la phase de commande du sous-pixel d'affichage bleu commence. Dans le présent mode de réalisation, le sous-pixel d'affichage bleu est activé et le signal sig passe à "1". Le signal data est égal au signal sig de sorte que le condensateur C1 du module CR est chargé par la source de courant CS jusqu'à l'instant t7 auquel les signaux sig et data passent à "0". Le signal Blue Done passe alors à "1".

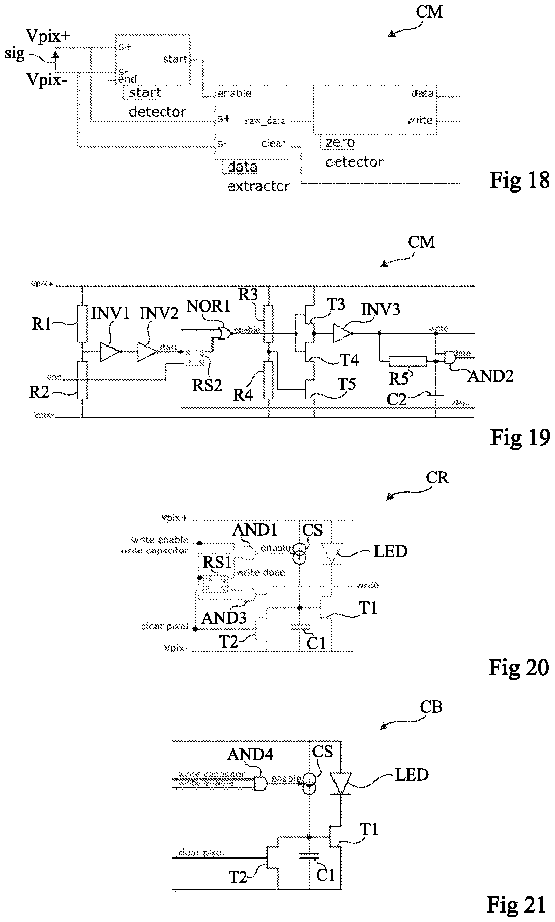

La figure 18 représente un schéma électrique équivalent d'un autre mode de réalisation du module CM adapté au cas où le signal end est fourni par la sortie write du module CG, les modules CR, CG correspondant par exemple au schéma électrique représenté sur la figure 20 décrite ci-après et le module CB correspondant par exemple au schéma électrique représenté sur la figure 21 décrite ci-après. Dans le présent mode de réalisation, pendant la phase de transmission S2, le signal data est égal au signal sig retardé d'une durée donnée ΔT et le signal write est égal au signal sig.

Le module CM comprend un bloc start detector comprenant une entrée s+ reliée à l'électrode au potentiel Vpix+ et une entrée s- reliée à l'électrode au potentiel Vpix- et fournissant un signal binaire start. Le bloc start detector est adapté à détecter que le signal sig, qui correspond à la tension entre les entrées s+ et s-, passe à "2" et est adapté à mettre le signal start à "1" lorsque le signal sig repasse à "0".

Le module CM comprend un bloc data extractor comprenant une entrée s+ reliée à l'électrode au potentiel Vpix+, une entrée s- reliée à l'électrode au potentiel Vpix- et une entrée enable recevant le signal start. Le bloc fournit le signal clear et le signal raw_data qui est extrait à partir du signal sig, et qui correspond par exemple à une version binaire du signal sig en dehors de la phase de sélection.

Le module CM comprend un bloc zéro detector recevant le signal raw_data et fournissant le signal write égal au signal raw_data et fournissant le signal data qui est égal au signal raw_data dont la durée de chaque impulsion à "1" est réduite de la durée ΔT, le début de chaque impulsion étant retardé de la durée ΔT et la fin de chaque impulsion n'étant pas modifiée de sorte que si l'impulsion du signal raw_data est inférieure à la durée ΔT, le signal data ne comprend pas d'impulsion correspondante.

La figure 19 représente un schéma électrique d'un mode de réalisation plus détaillé du module CM représenté en figure 18.

Le module CM comprend un premier pont diviseur de tension comprenant deux résistances R1 et R2 montées en série entre l'électrode au potentiel Vpix+ et l'électrode au potentiel Vpix-. Le point milieu du premier pont diviseur alimente une succession de deux inverseurs INV1 et INV2 en série, le deuxième inverseur INV2 fournissant le signal start. Le module CM comprend une bascule RS RS2 dont l'entrée S reçoit le signal start et dont l'entrée R, sensible aux fronts descendants, reçoit un signal end. Le signal end est fourni par la sortie write done du module CG tel que décrit en figure 20. Le module CM comprend une porte logique NON OU NOR1 dont la première entrée reçoit le signal start, dont la deuxième entrée est reliée à la sortie Q̅ de la bascule RS2 et qui fournit le signal enable.

Le module CM comprend un deuxième pont diviseur de tension comprenant deux résistances R3 et R4 montées en série entre l'électrode au potentiel Vpix+ et l'électrode au potentiel Vpix-. Le module CM comprend trois transistors MOS T3, T4 et T5 en série entre l'électrode au potentiel Vpix+ et l'électrode au potentiel Vpix-. Le transistor T3 est à canal P et les transistors T4 et T5 sont à canal N. Les grilles des transistors T3 et T4 reçoivent le signal enable. Le point milieu du deuxième pont diviseur alimente la grille du transistor T5.

La source du transistor T3 alimente un inverseur INV3 qui fournit le signal write. Le module CM comprend une porte logique ET AND2 à deux entrées dont la première entrée reçoit le signal write. Le module CM comprend une résistance R5 montée entre la sortie de l'inverseur INV3 et la deuxième entrée de la porte AND2. Le module CM comprend un condensateur C2 dont une électrode est reliée à la deuxième entrée de la porte AND2 et dont l'autre électrode est reliée à l'électrode au potentiel Vpix-. La sortie de la porte AND2 fournit le signal data.

La figure 20 représente un schéma électrique équivalent d'un autre mode de réalisation du module CR, le module CG pouvant être identique. Le module CR comprend l'ensemble des éléments du module représenté en figure 16 à la différence que l'entrée S de la bascule RS1 est reliée à l'entrée write enable du module CR et en ce qu'il comprend une porte logique ET à deux entrées AND3 dont la première entrée reçoit le signal Q, dont la deuxième entrée est reliée à l'entrée write enable et dont la sortie est reliée à la sortie write done.

La figure 21 représente un schéma électrique équivalent d'un autre mode de réalisation du module CB. Le module CB comprend l'ensemble des éléments du module représenté en figure 16 à la différence que la bascule RS1 n'est pas présente et que la porte logique AND1 à trois entrées est remplacée par une porte logique AND4 à deux entrées dont la première entrée est reliée à l'entrée write capacitor du module CB et dont la deuxième entrée est reliée à l'entrée write enable du module CB et fournissant le signal enable.

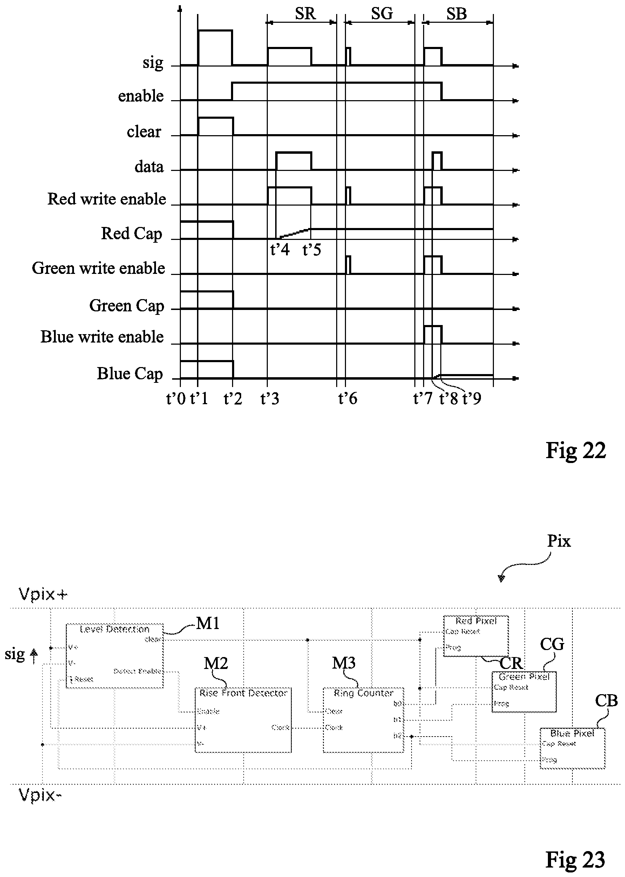

La figure 22 représente un chronogramme de signaux lors d'un cycle de commande du pixel d'affichage de la figure 18. On appelle t'0, t'1, t'2, t'3, t'4, t'5, t'6, t'7, t'8 et t'9 des instants successifs. Les signaux Red write enable, Green write enable et Blue write enable correspondent aux signaux reçus respectivement par les entrées write enable des modules CR, CG et CB.

Les signaux évoluent aux instants t'0, t'1, t'2 de la même façon que ce qui a été décrit précédemment pour les signaux t0, t1 et t2. A l'instant t'3, la phase de commande du sous-pixel d'affichage rouge commence. Dans le présent mode de réalisation, le sous-pixel d'affichage rouge est activé et le signal sig passe à "1". Le signal data est égal au signal sig retardé d'une durée ΔT de sorte que le condensateur C1 du module CR est chargé par la source de courant CS de l'instant t'4 jusqu'à l'instant t'5 auquel les signaux sig, data et Red write enable passent à "0". Le signal write done du module CR devient alors égal au signal Red write enable. A l'instant t'6, la phase de commande du sous-pixel d'affichage vert commence. Dans le présent mode de réalisation, le sous-pixel d'affichage vert n'est pas activé et le signal sig passe à "1" pendant une durée inférieure à ΔT. Le signal write et Green write enable passent également à "1" pendant cette durée très brève. Toutefois, le signal data lui reste à "0" de sorte que le condensateur C du module CG n'est pas chargé. Le signal write done du module CR devient alors égal au signal Green write enable. A l'instant t'7, la phase de commande du sous-pixel d'affichage bleu commence. Dans le présent mode de réalisation, le sous-pixel d'affichage bleu est activé et le signal sig passe à "1". Le signal data est égal au signal sig retardé d'une durée ΔT de sorte que le condensateur C du module CB est chargé par la source de courant CS de l'instant t'8 jusqu'à l'instant t'9 auquel les signaux sig, data, Red write enable, Green write enable et Blue write enable passent à "0".

Selon un mode de réalisation, le pixel d'affichage peut être réalisé avec moins de 150 transistors MOS, 5 résistances et 4 condensateurs. Il peut ainsi occuper une surface réduite.

La figure 23 représente un schéma électrique d'un autre mode de réalisation du pixel d'affichage Pix.

Le pixel d'affichage Pix est relié à l'une des électrodes de colonne 102 qui est au potentiel Vpix+ et à l'une des électrodes de rangée 104 qui est au potentiel Vpix-.

Le pixel d'affichage Pix comprend un module M1 de détection de niveau (Level détection), un module M2 de détection d'un front montant (Rise Front detector) et un compteur M3 (Ring Counter) et les modules CR, CG et CB de commande des sous-pixels d'affichage. Les composants électroniques des modules M1, M2 et M3 sont situés au niveau du circuit de commande 20. Les composants électroniques des modules CR, CG, CB peuvent être situés au niveau du circuit de commande 20 et/ou au niveau des circuits optoélectroniques 26.

Chaque module M1, M2, M3, CR, CG et CB est relié aux électrodes de colonne et de rangée associées 102, 104 aux potentiels Vpix+ et Vpix- pour leur alimentation électrique.

Le module M1 reçoit les valeurs de potentiel Vpix+ et Vpix- comme signaux d'entrée respectivement à des entrées V+ et V- et un signal binaire Reset et fournit un signal binaire Detect enable et un signal binaire Clear. Le module M2 reçoit les valeurs de potentiel Vpix+ et Vpix- comme signaux d'entrée respectivement à des entrées V+ et V- et le signal binaire Detect enable à une entrée Enable et fournit un signal binaire Clock. Le module M3 reçoit le signal binaire Clock et fournit trois signaux binaires b0, b1 et b2. Le front descendant de b2 réinitialise le module M1.

Chaque module CR, CG et CB comprend une entrée Cap reset et une entrée Prog. L'entrée Cap reset de chaque module CR, CG et CB reçoit le signal Detect enable. L'entrée Prog du module CR reçoit le signal b0, l'entrée Prog du module CG reçoit le signal b1 et l'entrée Prog du module CB reçoit le signal b2.

Dans le présent mode de réalisation, le module M1 est adapté à détecter que le pixel d'affichage est sélectionné par une augmentation du signal sig. Lorsqu'une sélection a été détectée, le module M2 détecte les fronts montants du signal sig. Les condensateurs des modules CR, CG et CB sont chargés séquentiellement, le passage d'un module à un autre étant déclenché par un front descendant du signal sig. Au début de chaque séquence, les condensateurs des modules CR, CG et CB sont déchargés.

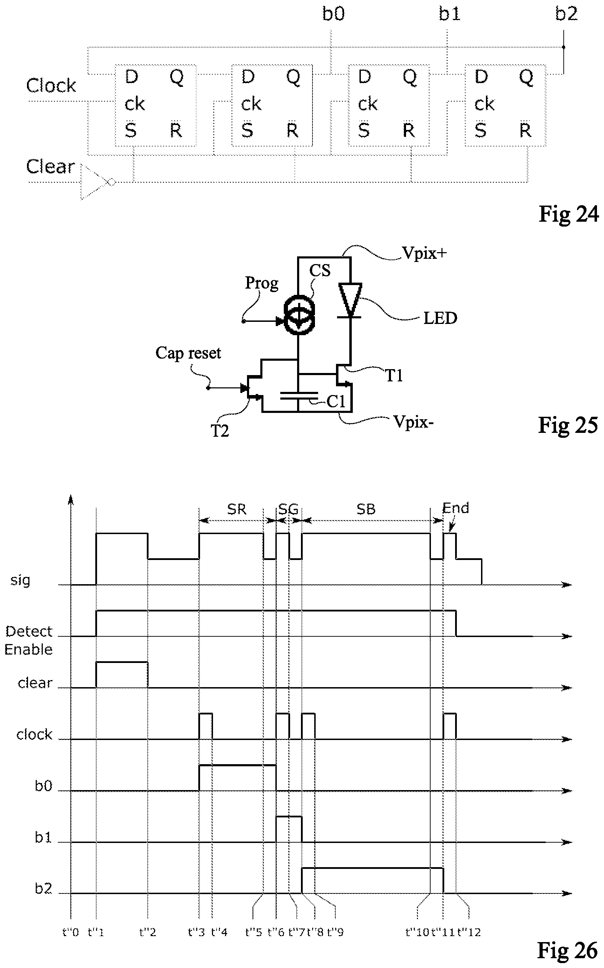

La figure 24 représente un mode de réalisation du module M3. Le module M3 comprend une succession de quatre bascules du type D avec entrées /S et /R asynchrones D1, D2, D3 et D4. L'entrée ck de chaque bascule D1, D2 et D3 reçoit le signal Clock. La sortie Q de la bascule D1 est reliée à l'entrée D de la bascule D2, la sortie Q de la bascule D2 est reliée à l'entrée D de la bascule D3 et la sortie Q de la bascule D3 est reliée à l'entrée D de la bascule D4. La sortie de la bascule D1 est à "1" à l'initialisation du compteur, tandis que les sorties des autres bascules sont à l'état logique "0". Le bit b0 correspond au signal fourni par la sortie Q de la bascule D2, le bit b1 correspond au signal fourni par la sortie Q de la bascule D3 et le bit b2 correspond au signal fourni par la sortie Q de la bascule D4. Le signal Clear issu du module M1 est fourni à l'inverseur INV9 et alimente l'entrée /S de la bascule D1 ainsi que les entrées /R des bascules D2, D3 et D4.

La figure 25 représente un mode de réalisation du module CR. Les modules CG et CB peuvent avoir la même structure. Le module CR a la même structure que le module CR représenté en figure 16 à la différence que la porte logique AND1 et la bascule RS1 ne sont pas présentes, que la source de courant CS est commandée par le signal reçu à l'entrée Prog du module CR et que la grille du transistor T2 est commandée par le signal reçu à l'entrée Cap_reset du module CR.

La figure 26 représente un chronogramme de signaux lors d'un cycle de commande du pixel d'affichage de la figure 23. On appelle t"0, t"1, t"2, t"3, t"4, t"5, t"6, t"7, t"8, t"9, t"10, t"11 et t"12 des instants successifs.

A l'instant t"0, les signaux sig, Cap_reset, detect enable, up, b0, b1 et b2 sont à "0". A l'instant t"1, le signal sig passe de "0" à "2". Le module M1 détecte que le pixel d'affichage est sélectionné et met le signal Clear et le signal detect enable à "1". A l'instant t"2, le signal sig passe à "1" et le module M1 passe le signal Clear à "0". A l'instant t"3, la phase SR de commande du sous-pixel d'affichage rouge commence. Dans le présent mode de réalisation, le sous-pixel d'affichage rouge est activé et le signal sig passe à "2". Le signal clock est mis à "1" de l'instant t"3 à l'instant t"4. Le signal b0 est mis à "1" à l'instant t"3. A l'instant t"5, le signal sig passe à "1". A l'instant t"6, le signal sig passe à "2", la phase SG de commande du sous-pixel d'affichage vert commence tandis que la phase de commande du sous-pixel rouge est terminée. Dans le présent mode de réalisation, le sous-pixel d'affichage vert est activé. Le signal clock est mis à "1" de l'instant t"6 à l'instant t"7. Le signal b1 est mis à "1" à l'instant t"6. Le signal b0 est mis à "0" à l'instant t"6. A l'instant t"8, le signal sig passe à "2", la phase SB de commande du sous-pixel d'affichage bleu commence. Dans le présent mode de réalisation, le sous-pixel d'affichage bleu est activé. Le signal clock est mis à "1" de l'instant t"8 à l'instant t"9. Le signal b2 est mis à "1" à l'instant t"8. Le signal b1 est mis à "0" à l'instant t"8. A l'instant t"10, le signal sig passe à "1". À l'instant t"11, le signal sig est mis à "2". La fin de la transaction est signalée. A l'instant t"11, le signal clock est mis à "1" et le signal b2 est mis à "0", la phase SB de commande du sous-pixel bleue se termine. A l'instant t"12, le signal sig passe à "1" puis à "0".

Selon un mode de réalisation, le pixel d'affichage peut être réalisé avec moins de 150 transistors MOS, 3 résistances et 4 condensateurs. Il peut ainsi occuper une surface réduite.

Afin d'optimiser les conditions de transfert des données, tous les modes de réalisation pourraient intégrer une fonction pour éteindre les pixels de la ligne ou de la colonne adressée pour la durée de la communication, ce qui limitera la charge à piloter lors du transfert des données. L'ajout d'une telle fonctionnalité pourrait se faire en réduisant la différence de potentiel Vpix+ - Vpix-.

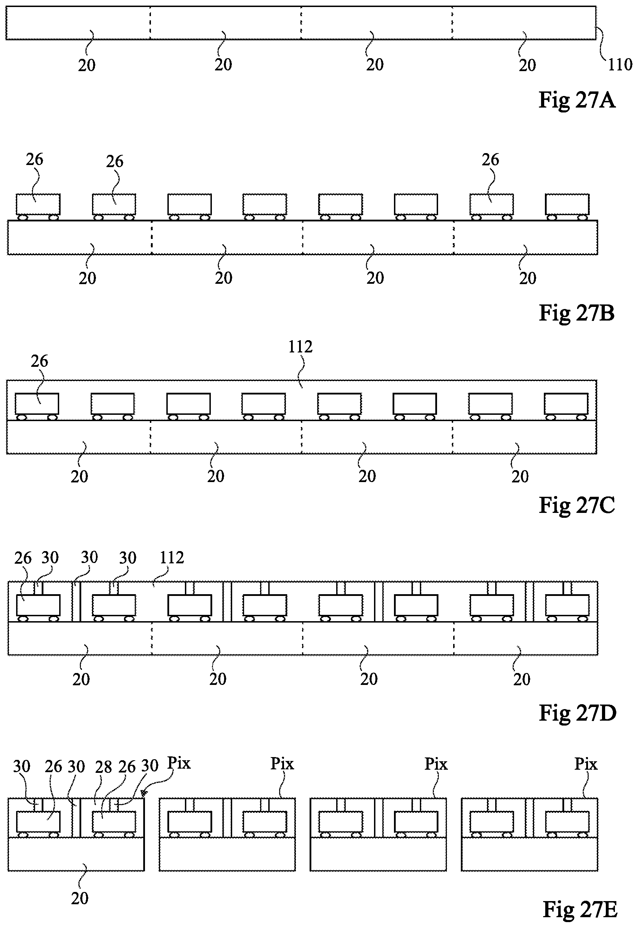

Les figures 27A à 27H sont des vues en coupe, partielles et schématiques, de structures obtenues à des étapes successives d'un mode de réalisation d'un procédé de fabrication du dispositif optoélectronique 10 représenté sur les figures 1 et 2, qui ne fait pas partie de l'invention telle que revendiquée.

La figure 27A représente la structure obtenue après la fabrication d'un circuit électronique 110 comprenant plusieurs exemplaires du circuit de commande 20 souhaité, quatre exemplaires du circuit de commande 20 étant représentés à titre d'exemple en figure 27A. Le procédé de fabrication du circuit électronique 110 peut comprendre des étapes classiques d'un procédé de fabrication d'un circuit intégré.

La figure 27B représente la structure obtenue après avoir fixé les circuits optoélectroniques 26 sur le circuit électronique 110. Les méthodes d'assemblage des circuits optoélectroniques 26 sur le circuit électronique 110 peuvent comprendre des opérations de brasage.

La figure 27C représente la structure obtenue après le dépôt d'une couche isolante électriquement 112 recouvrant les circuits optoélectroniques 26 et le circuit électronique 110 entre les circuits optoélectroniques 26. La couche isolante 112 est du même matériau que les portions isolantes 28 décrites précédemment. La couche isolante 112 peut être du SiO₂, SiN, Al₂O₃, ZrO₂, HfO₂ ou tout autre matériau diélectrique déposé par dépôt chimique en phase vapeur (CVD, sigle anglais pour Chemical Vapor Déposition), dépôt chimique en phase vapeur assisté par plasma (PECVD, sigle anglais pour Plasma Enhanced Chemical Vapor Deposition), dépôt de couches minces atomiques (ALD, sigle anglais pour Atomic Layer Déposition) ou pulvérisation cathodique.

La figure 27D représente la structure obtenue après la formation des éléments conducteurs 30 dans la couche isolante 112. Les éléments conducteurs 30 peuvent être formés en gravant des ouvertures dans la couche isolante 112 s'arrêtant sur les circuits optoélectroniques 26 et/ou les circuits de commande 20, en déposant une couche conductrice sur l'ensemble de la structure obtenue et en retirant la partie de la couche conductrice en dehors des ouvertures.

La figure 27E représente la structure obtenue après la découpe du circuit électronique 110 et de la couche isolante 112 pour délimiter les pixels d'affichage Pix.

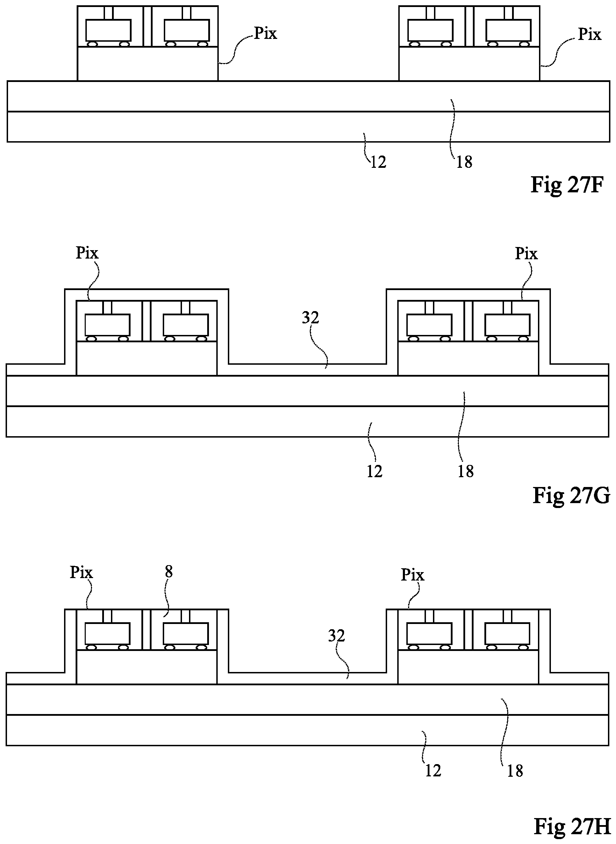

La figure 27F représente la structure obtenue après avoir fixé les pixels d'affichage Pix à la couche d'électrode 18 qui a été déposée au préalable sur le support 12. A titre d'exemple, chaque pixel d'affichage Pix peut être fixé à la couche d'électrode 18 par collage moléculaire ou par l'intermédiaire d'un matériau de collage, notamment une colle époxy conductrice électriquement.

La figure 27G représente la structure obtenue après avoir formé la couche isolante 32 sur les pixels d'affichage Pix et sur la couche d'électrode 18 entre les pixels d'affichage Pix. La couche isolante 32 peut être du SiO₂, SiN, Al₂O₃, ZrO₂, HfO₂ ou tout autre matériau diélectrique.

La figure 27H représente la structure obtenue après le retrait de la couche isolante 32 au sommet de chaque pixel d'affichage Pix. Selon un mode de réalisation, le retrait peut être réalisé par polissage mécano-chimique ou CMP (sigle anglais pour Chemical Mechanical Planarization) avec arrêt sur les portions isolantes 28. Selon un autre mode de réalisation, ceci peut être obtenu par gravure chimique de la couche isolante 32. Selon un autre mode de réalisation, le retrait peut être réalisé par un procédé dit lift-off comprenant le dépôt d'une couche sacrificielle au sommet de chaque pixel d'affichage Pix avant le dépôt de la couche isolante 32, et, après le dépôt de la couche isolante 32, le retrait de la couche sacrificielle et de la partie de la couche isolante 32 recouvrant la couche sacrificielle.

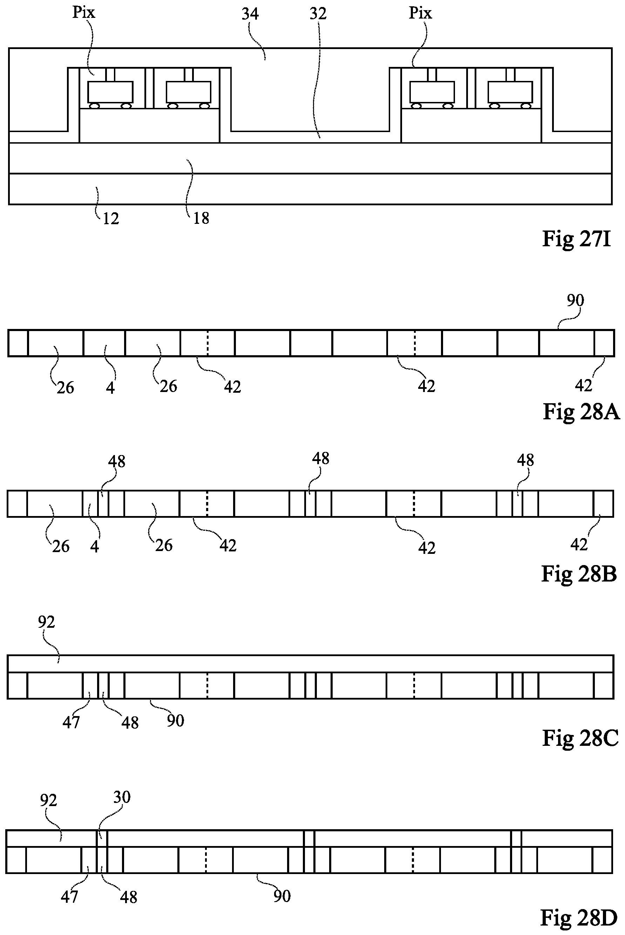

La figure 27I représente la structure obtenue après la formation de la couche d'électrode 34. La couche d'électrode 34 peut être du TCO déposé par CVD, PECVD, ALD, pulvérisation cathodique ou évaporation.

Les figures 28A à 28D sont des vues en coupe, partielles et schématiques, de structures obtenues à des étapes successives d'un mode de réalisation d'un procédé de fabrication du dispositif optoélectronique représenté sur la figure 4B, qui ne fait pas partie de l'invention telle que revendiquée.

La figure 28A représente la structure obtenue après la formation d'un circuit optoélectronique 90 comprenant plusieurs exemplaires du circuit optoélectronique 42, trois exemplaires du circuit optoélectronique 42 étant représentés à titre d'exemple en figure 27A. A titre d'exemple, en figure 28A, chaque circuit optoélectronique 42 est représenté comprenant deux circuits optoélectroniques 26 séparés par la portion 47.

La figure 28B représente la structure obtenue après la formation des TSV 48 traversant les circuits optoélectroniques 64. Chaque TSV 48 peut être formé en gravant une ouverture traversant le circuit optoélectronique 90. Cette ouverture peut avoir une section droite circulaire ou rectangulaire. La gravure peut être une gravure ionique réactive profonde (DRIE, acronyme anglais pour Deep Reactive Ion Etching). Une couche isolante est alors déposée sur les parois de l'ouverture. La couche isolante est, par exemple, réalisée par dépôt conforme par PECVD ou par dépôt conforme d'un polymère isolant. La couche isolante a une épaisseur comprise entre 10 nm et 5000 nm, par exemple d'environ 3 µm. Le remplissage du TSV peut alors être réalisé par dépôt électrolytique de cuivre.

La figure 28C représente la structure obtenue après le dépôt d'une couche isolante 92 sur le circuit optoélectronique 90. La couche isolante 92 est du même matériau que les portions isolantes 28 décrites précédemment. La couche isolante 92 peut être déposée par CVD, PECVD, ALD ou pulvérisation cathodique.

La figure 28D représente la structure obtenue après la formation des éléments conducteurs 30 dans la couche isolante 92.

Les étapes ultérieures du procédé peuvent être les mêmes que celles décrites précédemment en relation avec les figures 27E à 27I.

Divers modes de réalisation avec diverses variantes ont été décrits ci-dessus. On notera que l'homme de l'art pourra combiner divers éléments de ces divers modes de réalisation et variantes sans faire preuve d'activité inventive. A titre d'exemple, le schéma électrique représenté sur la figure 3 peut être mis en oeuvre avec la structure du dispositif 40 représentée en figure 4B et le schéma électrique représenté sur la figure 5 peut être mis en oeuvre avec la structure du dispositif 10 représentée sur les figures 1 et 2.

## Revendications

1. Procédé de commande d'un dispositif optoélectronique (10 ; 40 ; 50 ; 60 ; 70) comprenant des pixels d'affichage (Pix) agencés en rangées et en colonnes, chaque pixel d'affichage comprenant un circuit électronique (20 ; CM) et au moins un premier circuit optoélectronique (26 ; 42 ; CR, CG, CB) relié au circuit électronique et comprenant au moins une première diode électroluminescente (LED), le dispositif optoélectronique comprenant en outre des premières électrodes (102) s'étendant selon les rangées, chaque première électrode étant connectée aux circuits électroniques de pixels d'affichage d'au moins l'une des rangées, des deuxièmes électrodes (104) s'étendant selon les colonnes, chaque deuxième électrode étant connectée aux circuits électroniques de pixels d'affichage d'au moins l'une des colonnes, et un circuit de commande des premières et deuxièmes électrodes, le procédé étant **caractérisé en ce qu'**il comprend, dans une première phase, l'activation des circuits électroniques connectés à l'une des premières électrodes et à l'une des deuxièmes électrodes par les étapes suivantes réalisées simultanément :
amener l'une des premières électrodes à un premier potentiel (V1), les autres premières électrodes étant maintenues à un deuxième potentiel (V0) strictement inférieur au premier potentiel ; et
amener l'une des deuxièmes électrodes à un troisième potentiel (V2) strictement inférieur au deuxième potentiel, les autres deuxièmes électrodes étant maintenues à un quatrième potentiel (V3) strictement supérieur au troisième potentiel et strictement inférieur au deuxième potentiel.

2. Procédé de commande selon la revendication 1, comprenant, après la première phase, une deuxième phase comprenant la transmission de données aux circuits électroniques (20 ; CM) connectés à ladite une des premières électrodes (102) et à ladite une des deuxièmes électrodes (104) en faisant varier le potentiel de ladite une des premières électrodes entre le premier potentiel et le deuxième potentiel et en maintenant le potentiel de ladite une des deuxièmes électrodes au quatrième potentiel.

3. Procédé de commande selon la revendication 2, comprenant, pendant la deuxième phase, la transmission de signaux à durée discrète et la transmission de signaux à durée non discrète.

4. Procédé de commande selon la revendication 2 ou 3, dans lequel, pendant la deuxième phase, les circuits électroniques (20 ; CM) reliés à ladite une des premières électrodes (102) et non reliés à ladite une des deuxièmes électrodes (104) ne traitent pas les données transmises.

5. Procédé de commande selon l'une quelconque des revendications 2 à 4, comprenant l'extinction des diodes électroluminescentes (LED) des pixels d'affichage (Pix) reliés à ladite une des premières électrodes (102) et/ou à ladite une des deuxièmes électrodes (104).

6. Procédé de commande selon l'une quelconque des revendications 1 à 5, dans lequel chaque premier circuit optoélectronique (CR, CG, CB) comprend un premier transistor (T1) monté en série avec la première diode électroluminescente (LED), la deuxième phase comprenant le maintien de ladite une des premières électrodes (102) au premier potentiel pendant une première durée et dans lequel le premier transistor est commandé à un premier niveau de conduction qui dépend de la première durée.

7. Procédé de commande selon la revendication 6, dans lequel chaque pixel d'affichage comprend au moins un deuxième circuit optoélectronique (26 ; 42 ; CR, CG, CB) relié au circuit électronique (20 ; CM) dudit pixel d'affichage et comprenant au moins une deuxième diode électroluminescente (LED) et un deuxième transistor (T1) monté en série avec la deuxième diode électroluminescente (LED), la deuxième phase comprenant le maintien de ladite une des premières électrodes (102) au premier potentiel pendant une deuxième durée et dans lequel le deuxième transistor est commandé à un deuxième niveau de conduction qui dépend de la troisième durée.

8. Procédé de commande selon la revendication 7, dans lequel chaque pixel d'affichage (Pix) comprend au moins un troisième circuit optoélectronique (26 ; 42 ; CR, CG, CB) relié au circuit électronique dudit pixel d'affichage et comprenant au moins une troisième diode électroluminescente (LED) et un troisième transistor (T1) monté en série avec la troisième diode électroluminescente (LED), la deuxième phase comprenant le maintien de ladite une des premières électrodes (102) au premier potentiel pendant une troisième durée et dans lequel le troisième transistor est commandé à un troisième niveau de conduction qui dépend de la troisième durée.

9. Procédé de commande selon la revendication 8, dans lequel les première, deuxième et troisième durées sont successives, ladite une des premières électrodes (102) étant maintenue au deuxième potentiel entre la première durée et la deuxième durée et pendant la deuxième durée et la troisième durée.

10. Dispositif optoélectronique (10 ; 40 ; 50 ; 60 ; 70) comprenant des pixels d'affichage (Pix) agencés en rangées et en colonnes, chaque pixel d'affichage comprenant un circuit électronique (20) et au moins un premier circuit optoélectronique (26 ; 42 ; CR, CG, CB) relié au circuit électronique et comprenant au moins une première diode électroluminescente (LED), le dispositif optoélectronique comprenant en outre des premières électrodes (102) s'étendant selon les rangées, chaque première électrode étant connectée aux circuits électroniques de pixels d'affichage d'au moins l'une des rangées, des deuxièmes électrodes (104) s'étendant selon les colonnes, chaque deuxième électrode étant connectée aux circuits électroniques de pixels d'affichage d'au moins l'une des colonnes, et un circuit de commande des premières et deuxièmes électrodes le dispositif optoélectronique étant **caractérisé en ce que** ledit circuit de commande est configuré pour, pendant une première phase, simultanément :
amener l'une des premières électrodes à un premier potentiel, les autres premières électrodes étant maintenues à un deuxième potentiel strictement inférieur au premier potentiel ; et
amener l'une des deuxièmes électrodes à un troisième potentiel strictement inférieur au deuxième potentiel, les autres deuxièmes électrodes étant maintenues à un quatrième potentiel strictement supérieur au troisième potentiel et strictement inférieur au deuxième potentiel,
d'où il résulte l'activation des circuits électroniques connectés à ladite une des premières électrodes et à ladite une des deuxièmes électrodes.

11. Dispositif selon la revendication 10, dans lequel le circuit de commande est adapté, après la première phase, pendant une deuxième phase, à transmettre des données aux circuits électroniques (20 ; CM) connectés à ladite une des premières électrodes (102) et à ladite une des deuxièmes électrodes (104) en faisant varier le potentiel de ladite une des premières électrodes entre le premier potentiel et le deuxième potentiel et en maintenant le potentiel de ladite une des deuxièmes électrodes au quatrième potentiel.

12. Dispositif selon la revendication 11, dans lequel le circuit de commande est adapté, pendant la deuxième phase, à transmettre des signaux à durée discrète et des signaux à durée non discrète.

13. Dispositif selon la revendication 11 ou 12, dans lequel, pendant la deuxième phase, les circuits électroniques (20 ; CM) reliés à ladite une des premières électrodes (102) et non reliés à ladite une des deuxièmes électrodes (104) sont adaptés à ne pas traiter les données transmises.

14. Dispositif selon l'une quelconque des revendications 11 à 13, dans lequel les circuits électroniques (20 ; CM) reliés à ladite une des premières électrodes (102) et/ou à ladite une des deuxièmes électrodes (104) sont adaptés à éteindre les diodes électroluminescentes (LED) associées.

15. Dispositif selon l'une quelconque des revendications 11 à 14, dans lequel chaque premier circuit optoélectronique (CR, CG, CB) comprend un premier transistor (T1) monté en série avec la première diode électroluminescente (LED), le circuit de commande étant adapté, pendant la deuxième phase, à maintenir ladite une des premières électrodes (102) au premier potentiel pendant une première durée, le premier circuit optoélectronique étant adapté à rendre passant le premier transistor à un premier niveau de conduction qui dépend de la première durée.

16. Dispositif selon la revendication 15, dans lequel chaque pixel d'affichage (Pix) comprend au moins un deuxième circuit optoélectronique (26 ; 42 ; CR, CG, CB) relié au circuit électronique (20 ; CM) dudit pixel d'affichage et comprenant au moins une deuxième diode électroluminescente (LED) et un deuxième transistor (T1) monté en série avec la deuxième diode électroluminescente (LED), le circuit de commande étant adapté, pendant la deuxième phase, à maintenir ladite une des premières électrodes au premier potentiel pendant une deuxième durée, le deuxième circuit optoélectronique étant adapté à rendre passant le deuxième transistor à un deuxième niveau de conduction qui dépend de la deuxième durée.

17. Dispositif selon la revendication 16, dans lequel chaque pixel d'affichage comprend au moins un troisième circuit optoélectronique (26 ; 42 ; CR, CG, CB) relié au circuit électronique et comprenant au moins une troisième diode électroluminescente (LED) et un troisième transistor (T1) monté en série avec la troisième diode électroluminescente (LED), le circuit de commande étant adapté, pendant la deuxième phase, à maintenir ladite une des premières électrodes (102) au premier potentiel pendant une troisième durée, le troisième circuit optoélectronique étant adapté à rendre passant le troisième transistor à un troisième niveau de conduction qui dépend de la troisième durée.

18. Dispositif selon la revendication 17, dans lequel les première, deuxième et troisième durées sont successives, le circuit de commande étant adapté à maintenir ladite une des premières électrodes (102) au deuxième potentiel entre la première durée et la deuxième durée et pendant la deuxième durée et la troisième durée.

## Patentansprüche

1. Ein Verfahren zur Steuerung einer optoelektronischen Vorrichtung (10; 40; 50; 60; 70), die Anzeigepixel (Pix) aufweist, die in Zeilen und Spalten angeordnet sind, wobei jedes Anzeigepixel eine elektronische Schaltung (20; CM) und wenigstens eine erste optoelektronische Schaltung (26; 42; CR, CG, CB ) aufweist, die mit der elektronischen Schaltung gekoppelt ist und wenigstens eine erste Leuchtdiode (LED) aufweist, wobei die optoelektronische Vorrichtung ferner erste Elektroden (102) aufweist, die sich entlang der Zeilen erstrecken, wobei jede erste Elektrode mit den elektronischen Schaltungen von Anzeigepixeln von wenigstens einer der Zeilen verbunden ist, zweite Elektroden (104), die sich entlang der Spalten erstrecken, wobei jede zweite Elektrode mit den elektronischen Schaltungen von Anzeigepixeln von wenigstens einer der Spalten verbunden ist, und eine Schaltung zum Steuern der ersten und zweiten Elektroden, wobei das Verfahren **dadurch gekennzeichnet ist, dass** in einer ersten Phase Aktivieren der elektronischen Schaltungen aufweist, die mit einer der ersten Elektroden und mit einer der zweiten Elektroden verbunden sind, und zwar durch die folgenden, gleichzeitig ausgeführten Schritte:
Bringen einer der ersten Elektroden auf ein erstes Potential (V1), wobei die anderen ersten Elektroden auf einem zweiten Potential (V0) gehalten werden, das kleiner als das erste Potential ist; und
Bringen einer der zweiten Elektroden auf ein drittes Potential (V2), das kleiner als das zweite Potential ist, wobei die anderen zweiten Elektroden auf einem vierten Potential (V3) gehalten werden, das größer als das dritte Potential und kleiner als das zweite Potential ist.

2. Das Verfahren zur Steuerung nach Anspruch 1, das nach der ersten Phase eine zweite Phase aufweist, die Übertragen von Daten an die elektronischen Schaltungen (20; CM) aufweist, die mit der einen der ersten Elektroden (102) und mit der einen der zweiten Elektroden (104) verbunden sind, und zwar durch Variieren des Potenzials der einen der ersten Elektroden zwischen dem ersten Potenzial und dem zweiten Potenzial und durch Halten des Potenzials der einen der zweiten Elektroden auf dem vierten Potenzial.

3. Das Verfahren zur Steuerung nach Anspruch 2, das während der zweiten Phase Übertragen von Signalen mit einer diskreten Dauer und Übertragen von Signalen mit einer nicht-diskreten Dauer aufweist.

4. Das Verfahren zur Steuerung nach Anspruch 2 oder 3, wobei während der zweiten Phase die elektronischen Schaltungen (20; CM), die mit der einen der ersten Elektroden (102) gekoppelt sind und die nicht mit der einen der zweiten Elektroden (104) gekoppelt sind, die übertragenen Daten nicht verarbeiten.

5. Das Verfahren zur Steuerung nach einem der Ansprüche 2 bis 4, aufweisend Ausschalten der Leuchtdioden (LED) der Anzeigepixel (Pix), die mit der einen der ersten Elektroden (102) und/oder der einen der zweiten Elektroden (104) verbunden sind.

6. Das Verfahren zur Steuerung nach einem der Ansprüche 1 bis 5, wobei jede erste optoelektronische Schaltung (CR, CG, CB) einen ersten Transistor (T1) aufweist, der mit der ersten Leuchtdiode (LED) in Reihe angeordnet ist, wobei die zweite Phase Halten der einen der ersten Elektroden (102) für eine erste Zeitspanne auf dem ersten Potential aufweist, und wobei der erste Transistor auf einem ersten Leitfähigkeitsniveau gesteuert wird, das von der ersten Zeitspanne abhängt.

7. Das Verfahren zur Steuerung nach Anspruch 6, wobei jedes Anzeigepixel wenigstens eine zweite optoelektronische Schaltung (26; 42; CR, CG, CB) aufweist, die mit der elektronischen Schaltung (20; CM) des Anzeigepixels gekoppelt ist und wenigstens eine zweite Leuchtdiode (LED) und einen zweiten Transistor (T1) aufweist, der mit der zweiten Leuchtdiode (LED) in Reihe angeordnet ist, wobei die zweite Phase Halten der einen der ersten Elektroden (102) für eine zweite Zeitspanne auf dem ersten Potential aufweist, und wobei der zweite Transistor auf einem zweiten Leitfähigkeitsniveau gesteuert wird, das von der zweiten Zeitspanne abhängt.

8. Das Verfahren zur Steuerung nach Anspruch 7, wobei jedes Anzeigepixel (Pix) wenigstens eine dritte optoelektronische Schaltung (26; 42; CR, CG, CB) aufweist, die mit der elektronischen Schaltung des Anzeigepixels gekoppelt ist und wenigstens eine dritte Leuchtdiode (LED) und einen dritten Transistor (T1) aufweist, der mit der dritten Leuchtdiode (LED) in Reihe angeordnet ist, wobei die zweite Phase Halten der einen der ersten Elektroden (102) auf dem ersten Potential für eine dritte Zeitspanne aufweist und wobei der dritte Transistor auf einem dritten Leitfähigkeitsniveau gesteuert wird, das von der dritten Zeitspanne abhängt.

9. Das Verfahren zur Steuerung nach Anspruch 8, wobei die erste, zweite und dritte Zeitspanne aufeinander folgen, wobei die eine der ersten Elektroden (102) auf dem zweiten Potential gehalten wird, und zwar zwischen der ersten Zeitspanne und der zweiten Zeitspanne und während der zweiten Zeitspanne und der dritten Zeitspanne.

10. Eine optoelektronische Vorrichtung (10; 40; 50; 60; 70), die Anzeigepixel (Pix) aufweist, die in Zeilen und Spalten angeordnet sind, wobei jedes Anzeigepixel eine elektronische Schaltung (20) und wenigstens eine erste optoelektronische Schaltung (26; 42; CR, CG, CB) aufweist, die mit der elektronischen Schaltung gekoppelt ist und wenigstens eine erste Leuchtdiode (LED) aufweist, wobei die optoelektronische Vorrichtung ferner erste Elektroden (102) aufweist, die sich entlang der Zeilen erstrecken, wobei jede erste Elektrode mit den elektronischen Schaltungen von Anzeigepixeln von wenigstens einer der Zeilen verbunden ist, zweite Elektroden (104), die sich entlang der Spalten erstrecken, wobei jede zweite Spalte mit den elektronischen Schaltungen von Anzeigepixeln von wenigstens einer der Spalten verbunden ist, und eine Schaltung zum Steuern der ersten und zweiten Elektroden, wobei das optoelektronische Gerät **dadurch gekennzeichnet ist, dass** die Steuerschaltung so konfiguriert ist, während einer ersten Phase gleichzeitig zum:
Bringen einer der ersten Elektroden auf ein erstes Potential, wobei die anderen ersten Elektroden auf einem zweiten Potential gehalten werden, das kleiner als das erste Potential ist; und
Bringen einer der zweiten Elektroden auf ein drittes Potential, das kleiner als das zweite Potential ist, wobei die anderen zweiten Elektroden auf einem vierten Potential gehalten werden, das größer als das dritte Potential und kleiner als das zweite Potential ist,
was zur Aktivierung der elektronischen Schaltungen führt, die mit der einen der ersten Elektroden und mit der einen der zweiten Elektroden verbunden sind.

11. Die Vorrichtung nach Anspruch 10, wobei die Schaltung zum Steuern eingerichtet ist, nach der ersten Phase, während einer zweiten Phase, zum Übertragen von Daten an die elektronischen Schaltungen (20; CM), die mit der einen der ersten Elektroden (102) und der einen der zweiten Elektroden (104) verbunden sind, und zwar durch Variieren des Potenzials der einen der ersten Elektroden zwischen dem ersten Potenzial und dem zweiten Potenzial und durch Halten des Potenzials der einen der zweiten Elektroden auf dem vierten Potenzial.

12. Die Vorrichtung nach Anspruch 11, wobei die Schaltung zum Steuern eingerichtet ist, während der zweiten Phase, zum Übertragen von Signalen mit einer diskreten Dauer und Signalen mit einer nicht-diskreten Dauer.

13. Die Vorrichtung nach Anspruch 11 oder 12, wobei, während der zweiten Phase, die elektronischen Schaltungen (20; CM), die mit der einen der ersten Elektroden (102) gekoppelt sind und die nicht mit der einen der zweiten Elektroden (104) gekoppelt sind, eingerichtet sind, die übertragenen Daten nicht zu verarbeiten.

14. Die Vorrichtung nach einem der Ansprüche 11 bis 13, wobei die elektronischen Schaltungen (20; CM), die mit der einen der ersten Elektroden (102) und/oder mit der einen der zweiten Elektroden (104) verbunden sind, eingerichtet sind, die zugehörigen Leuchtdioden (LED) auszuschalten.

15. Die Vorrichtung nach einem der Ansprüche 11 oder 14, bei der jede erste optoelektronische Schaltung (CR, CG, CB) einen ersten Transistor (T1) aufweist, der mit der ersten Leuchtdiode (LED) in Reihe angeordnet ist, wobei die Steuerschaltung während der ersten Phase eingerichtet ist, die eine der ersten Elektroden (102) für eine erste Zeitspanne auf dem ersten Potential zu halten, wobei die erste optoelektronische Schaltung eingerichtet ist, den ersten Transistor auf einem ersten Leitfähigkeitsniveau einzuschalten, das von der ersten Zeitspanne abhängt.

16. Die Vorrichtung nach Anspruch 15, wobei jedes Anzeigepixel (Pix) wenigstens eine zweite optoelektronische Schaltung (26; 42; CR, CG, CB) aufweist, die mit der elektronischen Schaltung (20; CM) des Anzeigepixels gekoppelt ist und wenigstens eine zweite Leuchtdiode (LED) und einen zweiten Transistor (T1) aufweist, der mit der zweiten Leuchtdiode (LED) in Reihe angeordnet ist, wobei die Steuerschaltung während der zweiten Phase eingerichtet ist, die eine der ersten Elektroden während einer zweiten Zeitspanne auf dem ersten Potential zu halten, wobei die zweite optoelektronische Schaltung eingerichtet ist, den zweiten Transistor auf einem zweiten Leitfähigkeitsniveau einzuschalten, das von der zweiten Zeitspanne abhängt.

17. Die Vorrichtung nach Anspruch 16, wobei jedes Anzeigepixel wenigstens eine dritte optoelektronische Schaltung (26; 42; CR, CG, CB) aufweist, die mit der elektronischen Schaltung gekoppelt ist und wenigstens eine dritte Leuchtdiode (LED) und einen dritten Transistor (T1) aufweist, der mit der dritten Leuchtdiode (LED) in Reihe angeordnet ist, wobei die Steuerschaltung eingerichtet ist, während der zweiten Phase die eine der ersten Elektroden (102) für eine dritte Zeitspanne auf dem ersten Potential zu halten, wobei die dritte optoelektronische Schaltung eingerichtet ist, den dritten Transistor auf einem dritten Leitfähigkeitsniveau einzuschalten, das von der dritten Zeitspanne abhängt.

18. Die Vorrichtung nach Anspruch 17, wobei die erste, zweite und dritte Zeitspanne aufeinander folgen, wobei die Steuerschaltung eingerichtet ist, zum Halten der eine der ersten Elektroden (102) auf dem zweiten Potential, und zwar zwischen der ersten Zeitspanne und der zweiten Zeitspanne und während der zweiten Zeitspanne und der dritten Zeitspanne.

## Claims

1. A method of controlling an optoelectronic device (10; 40; 50; 60; 70) comprising display pixels (Pix) arranged in rows and in columns, each display pixel comprising an electronic circuit (20; CM) and at least one first optoelectronic circuit (26; 42; CR, CG, CB) coupled to the electronic circuit and comprising at least one first light-emitting diode (LED), the optoelectronic device further comprising first electrodes (102) extending along the rows, each first electrode being connected to the electronic circuits of display pixels of at least one of the rows, second electrodes (104) extending along the columns, each second electrode being connected to the electronic circuits of display pixels of at least one of the columns, and a circuit for controlling the first and second electrodes, the method being **characterized in that** it comprises, in a first phase, activating the electronic circuits connected to one of the first electrodes and to one of the second electrodes by the following steps, carried out simultaneously:
taking one of the first electrodes to a first potential (V1), the other first electrodes being maintained at a second potential (V0) smaller than the first potential; and
taking one of the second electrodes to a third potential (V2) smaller than the second potential, the other second electrodes being maintained at a fourth potential (V3) greater than the third potential and smaller than the second potential.

2. The control method of claim 1, comprising, after the first phase, a second phase comprising transmitting data to the electronic circuits (20; CM) connected to said one of the first electrodes (102) and to said one of the second electrodes (104) by varying the potential of said one of the first electrodes between the first potential and the second potential and by maintaining the potential of said one of the second electrodes at the fourth potential.

3. The control method of claim 2, comprising, during the second phase, transmitting signals having a discrete duration and transmitting signals having a non-discrete duration.

4. The control method of claim 2 or 3, wherein, during the second phase, the electronic circuits (20; CM) coupled to said one of the first electrodes (102) and which are not coupled to said one of the second electrodes (104) do not process the transmitted data.

5. The control method of any of claims 2 to 4, comprising turning off the light-emitting diodes (LED) of the display pixels (Pix) coupled to said one of the first electrodes (102) and/or to said one of the second electrodes (104).

6. The control method of any of claims 1 to 5, wherein each first optoelectronic circuit (CR, CG, CB) comprises a first transistor (T1) series-assembled with the first light-emitting diode (LED), the second phase comprising maintaining said one of the first electrodes (102) at the first potential for a first time period and wherein the first transistor is controlled at a first conduction level which depends on the first time period.

7. The control method of claim 6, wherein each display pixel comprises at least one second optoelectronic circuit (26; 42; CR, CG, CB) coupled to the electronic circuit (20; CM) of said display pixel and comprising at least a second light-emitting diode (LED) and a second transistor (T1) series-assembled with the second light-emitting diode (LED), the second phase comprising maintaining said one of the first electrodes (102) at the first potential for a first time period and wherein the second transistor is controlled at a second conduction level which depends on the third time period.

8. The control method of claim 7, wherein each display pixel (Pix) comprises at least one third optoelectronic circuit (26; 42; CR, CG, CB) coupled to the electronic circuit of said display pixel and comprising at least a third light-emitting diode (LED) and a third transistor (T1) series-assembled with the third light-emitting diode (LED), the second phase comprising maintaining said one of the first electrodes (102) at the first potential for a third time period and wherein the third transistor is controlled at a third conduction level which depends on the third time period.

9. The control method of claim 8, wherein the first, second, and third time periods are successive, said one of the first electrodes (102) being maintained at the second potential between the first time period and the second time period and for the second time period and the third time period.

10. An optoelectronic device (10; 40; 50; 60; 70) comprising display pixels (Pix) arranged in rows and in columns, each display pixel comprising an electronic circuit (20) and at least one first optoelectronic circuit (26; 42; CR, CG, CB) coupled to the electronic circuit and comprising at least one first light-emitting diode (LED), the optoelectronic device further comprising first electrodes (102) extending along the rows, each first electrode being connected to the electronic circuits of display pixels of at least one of the rows, second electrodes (104) extending along the columns, each second column being connected to the electronic circuits of display pixels of at least one of the columns, and a circuit for controlling the first and second electrodes, the optoelectronic device being **characterized in that** said control circuit is configured, during a first, to simultaneously:
take one of the first electrodes to a first potential, the other first electrodes being maintained at a second potential smaller than the first potential; and
take one of the second electrodes to a third potential smaller than the second potential, the other second electrodes being maintained at a fourth potential greater than the third potential and smaller than the second potential,
which results in the activation of the electronic circuits connected to said one of the first electrodes and to said one of the second electrodes.

11. The device of claim 10, wherein the control circuit is capable, after the first phase, during a second phase, of transmitting data to the electronic circuits (20; CM) connected to said one of the first electrodes (102) and to said one of the second electrodes (104) by varying the potential of said one of the first electrodes between the first potential and the second potential and by maintaining the potential of said one of the second electrodes at the fourth potential.

12. The device of claim 11, wherein the control circuit is capable, during the second phase, of transmitting signals having a discrete duration and signals having a non-discrete duration.

13. The device of claim 11 or 12, wherein, during the second phase, the electronic circuits (20; CM) coupled to said one of the first electrodes (102) and which are not coupled to said one of the second electrodes (104) are capable of not processing the transmitted data.

14. The device of any of claims 11 to 13, wherein the electronic circuits (20; CM) coupled to said one of the first electrodes (102) and/or to said one of the second electrodes (104) are capable of turning off the associated light-emitting diodes (LED).

15. The device of any of claims 11 or 14, wherein each first optoelectronic circuit (CR, CG, CB) comprises a first transistor (T1) series-assembled with the first light-emitting diode (LED), the control circuit being capable, during the first phase, of maintaining said one of the first electrodes (102) at the first potential for a first time period, the first optoelectronic circuit being capable of turning on the first transistor at a first conduction level which depends on the first time period.

16. The device of claim 15, wherein each display pixel (Pix) comprises at least one second optoelectronic circuit (26; 42; CR, CG, CB) coupled to the electronic circuit (20; CM) of said display pixel and comprising at least a second light-emitting diode (LED) and a second transistor (T1) series-assembled with the second light-emitting diode (LED), the control circuit being capable, during the second phase, of maintaining said one of the first electrodes at the first potential for a second time period, the second optoelectronic circuit being capable of turning on the second transistor at a second conduction level which depends on the second time period.

17. The device of claim 16, wherein each display pixel comprises at least one third optoelectronic circuit (26; 42; CR, CG, CB) coupled to the electronic circuit and comprising at least a third light-emitting diode (LED) and a third transistor (T1) series-assembled with the third light-emitting diode (LED), the control circuit being capable, during the second phase, of maintaining said one of the first electrodes (102) at the first potential for a third time period, the third optoelectronic circuit being capable of turning on the third transistor at a third conduction level which depends on the third time period.

18. The device of claim 17, wherein the first, second, and third time periods are successive, the control circuit being capable of maintaining said one of the first electrodes (102) at the second potential between the first time period and the second time period and for the second time period and the third time period.
